(19) Europäisches Patentamt
European Patent Office
Office européen des brevets

(11) **EP 3 376 585 B1**

(12) **EUROPEAN PATENT SPECIFICATION**

(45) Date of publication and mention
of the grant of the patent:
**18.06.2025 Bulletin 2025/25**

(21) Application number: **17188520.5**

(22) Date of filing: **30.08.2017**

(51) International Patent Classification (IPC):
*H01M 10/42* (2006.01)     *G01F 1/00* (2022.01)
*G01F 3/00* (2006.01)     *H01M 10/48* (2006.01)
*H01M 10/635* (2014.01)     *G01R 31/367* (2019.01)
*G01R 31/392* (2019.01)     *G01R 31/396* (2019.01)

(52) Cooperative Patent Classification (CPC):
**G01R 31/367; G01R 31/392; G01R 31/396;
H01M 10/4207; H01M 10/482; H01M 10/486;
H01M 10/488; H01M 10/635;** H01M 2200/00;
Y02E 60/10; Y02T 10/70

(54) **BATTERY SAFETY EVALUATION APPARATUS, BATTERY SAFETY EVALUATION METHOD AND PROGRAM**

BATTERIESICHERHEITSBEWERTUNGSVORRICHTUNG, BATTERIESICHERHEITSBEWERTUNGSVERFAHREN UND -PROGRAMM

APPAREIL D'ÉVALUATION DE SÉCURITÉ DE BATTERIE, PROCÉDÉ D'ÉVALUATION DE SÉCURITÉ DE BATTERIE ET PROGRAMME

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **15.03.2017 JP 2017050332**

(43) Date of publication of application:
**19.09.2018 Bulletin 2018/38**

(73) Proprietor: **KABUSHIKI KAISHA TOSHIBA
Minato-ku
Tokyo
105-8001 (JP)**

(72) Inventors:
• **Morita, Tomokazu**
  **Tokyo, 105-8001 (JP)**
• **Fujita, Yumi**
  **Tokyo, 105-8001 (JP)**
• **Sugiyama, Nobukatsu**
  **Tokyo, 105-8001 (JP)**
• **Ishii, Ena**
  **Tokyo, 105-8001 (JP)**
• **Aratani, Wataru**
  **Tokyo, 105-8001 (JP)**

(74) Representative: **Hoffmann Eitle
Patent- und Rechtsanwälte PartmbB
Arabellastraße 30
81925 München (DE)**

(56) References cited:
JP-A- 2013 101 884     US-A1- 2007 120 537
US-A1- 2016 380 313

**Description**

FIELD

The present disclosure relate to a battery safety evaluation apparatus, a battery safety evaluation method and a program.

BACKGROUND

There is known high energy density of nonaqueous electrolyte secondary batteries such as lithium ion batteries, which are widely used for component batteries (unit cells or cells) of an assembled battery (battery pack). For example, a laptop PC uses an assembled battery composed of several cells, an electric vehicle uses an assembled battery composed of tens to hundreds of cells, and a power line system uses an assembled battery composed of ten thousand or more cells.

Meanwhile, there are also known risks of fuming, firing and the like of such nonaqueous electrolyte secondary batteries. Therefore, a device including an assembled battery generally has a plurality of safety devices such as a use stop device in order to secure safety. However, safety of cells cannot be nondestructively inspected, and firing of cells are difficult to be completely prevented.

Therefore, importance is recently placed on preventing a spreading fire to surrounding cells from a cell which gets firing in an assembled battery. To this end, tests such as a thermal chain test and a spreading fire resistance test are performed. A cell causes thermal runaway, or quick heat generation, under exposure to high temperature. Therefore, an assembled battery is designed with a temperature at which thermal runaway arises (thermal runaway temperature), a heat amount in thermal runaway, and the like taken into consideration. However, with a cell deteriorating, these values thereof vary. Therefore, in view of resistance to spreading fire, in order to evaluate and secure present safety of a storage battery system, it is needed to nondestructively examine the thermal runaway temperature and the like for the present storage battery.

US 2016/0380313 A1 describes a battery pack including an initial state estimation unit, a temperature estimation unit, and a determination unit. The internal state estimation unit estimates an internal state of a secondary battery based on measurement data. The temperature estimation unit estimates the temperature of the secondary battery based on the measurement data and the estimation parameter. The determination unit compares an absolute value of a temperature difference between a measured temperature of the secondary battery contained in the measurement data and the estimated temperature with one or more temperature threshold levels, and determines a temperature state of the secondary battery in accordance with a comparison result.

SUMMARY

According to the aspects of the present invention there is provided an apparatus, a method and a program for evaluating safety of a secondary battery nondestructively.

The apparatus, the method and the program according to the present invention are described in the claims.

BRIEF DESCRIPTION OF THE DRAWINGS

FIG. 1 is a block diagram illustrating an example of a schematic configuration of a power storage system including a battery safety evaluation apparatus according to a first arrangement;

FIG. 2 is a diagram illustrating an example of a flowchart on schematic processes of the battery safety evaluation apparatus of the first arrangement;

FIG. 3 illustrates an example of data regarding a current and a voltage during charge;

FIG. 4 illustrates an example of a flowchart of a process to be performed by an inner-state parameter calculator;

FIG. 5 illustrates an example of a flowchart of a process flow to be performed by a battery characteristic calculator;

FIG. 6A and 6B illustrate an example of graphs (charge amount-OCV curves) illustrating the relationships between a charge amount and an open circuit voltage;

FIG. 7 illustrates an example of a graph (an SOC-OCV curve) illustrating the relationship between an SOC and an open circuit voltage;

FIG. 8 illustrates an example of the relationships, at respective temperatures, between SOCs and reaction resistances Rct;

FIG. 9 is a diagram regarding resistive components;

FIG. 10 is a diagram illustrating an example of thermal stability data;

FIG. 11 is a diagram illustrating an example of a flowchart of a battery safety evaluation process;

FIG. 12 is a block diagram illustrating an example of a schematic configuration of a power storage system according to a second arrangement;

FIG. 13 is a diagram illustrating an example of a flowchart on schematic processes of a battery safety evaluation apparatus of the second arrangement;

FIG. 14 is a block diagram illustrating an example of a schematic configuration of a power storage system according to a third arrangement;

FIG. 15 is a diagram illustrating an example of a flowchart of a thermal stability data acquisition process; and

FIG. 16 is a block diagram illustrating an example of a hardware configuration in an arrangement of the present invention.

## DETAILED DESCRIPTION

A battery safety evaluation apparatus according to one aspect of the present invention includes a battery characteristic estimator, a heat amount estimator and an end-point cell temperature estimator (safety index calculator). The battery characteristic estimator estimates an estimation value of an inner state parameter of a first battery which is a secondary battery to be evaluated on the basis of data on voltage and current of the first battery measured in charging or discharging the first battery. The heat amount estimator estimates a heat amount of the first battery upon change of an external temperature on the basis of first reference data which is reference data at least indicating relationship between a heat amount of a secondary battery and the external temperature and is set to correspond to the first battery on the basis of the estimation value. The safety index calculator calculates a safety index regarding a temperature of the first battery upon change of the external temperature on the basis of the heat amount of the first battery.

Below, a description is given of arrangements of the present invention with reference to the drawings. The present invention is not limited to the arrangements.

(First Arrangement)

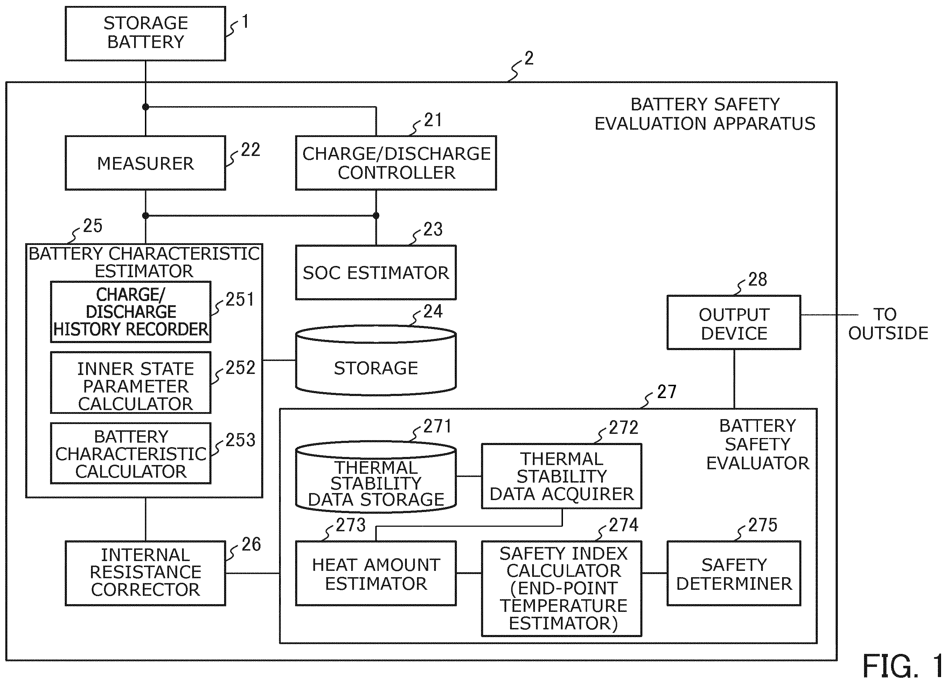

FIG. 1 is a block diagram illustrating an example of a schematic configuration of a power storage system including a battery safety evaluation apparatus according to a first arrangement. The power storage system includes a storage battery 1 (a first battery) and a battery safety evaluation apparatus 2. The battery safety evaluation apparatus 2 includes a charge/discharge controller 21, a measurer 22, an SOC (state of charge) estimator 23, a storage 24, a battery characteristic estimator 25, an internal-resistance corrector 26, and a battery safety evaluator 27 and an output device 28. The battery characteristic estimator 25 includes a charge/discharge history recorder 251, an inner-state parameter calculator 252, and a battery characteristic calculator 253. The battery safety evaluator 27 includes a thermal stability data storage 271, a thermal stability data acquirer (reference data acquirer) 272, a heat amount estimator 273, and a safety index calculator (end-point cell temperature estimator) 274, and a safety determiner 275.

The battery safety evaluation apparatus 2 realized by a CPU, a control circuit or the like may be provided to the storage battery 1 such that the battery safety evaluation apparatus 2 is realized so as to be integrated with the storage battery 1.

The storage battery 1 is a battery to be evaluated in its safety by the battery safety evaluation apparatus 2. This evaluation of safety indicates whether the storage battery 1 is safe even under exposure of the storage battery 1 to high temperature. Since it is supposed that this evaluation is performed in view of resistance to spreading fire of an assembled battery (battery pack), the storage battery 1 is supposed to be any of a nonaqueous electrolyte secondary battery such as a lithium ion secondary battery and an assembled battery composed of nonaqueous electrolyte secondary batteries. However, the storage battery 1 is not limited to these but may be any chargeable and dischargeable secondary battery.

Notably, charge/discharge may mean any one of charge and discharge or may mean both of these. Moreover, in the description below, unless otherwise mentioned, the term "storage battery" includes an assembled battery, a battery module and a unit cell.

The storage battery 1 may be a storage battery for storage battery-installed devices such, for example, as cellular phones, laptop computers, electric bicycles, electric vehicles, hybrid vehicle using both electricity and gasoline, and drones. Further, the storage battery 1 may be a stationary storage battery that is installed for each structure such as a private house, a building, and a factory. The storage battery 1 may be a storage battery linked with, or interconnected with a power generation system.

The battery safety evaluation apparatus 2 evaluates safety of the storage battery 1. Specifically, the battery safety evaluation apparatus 2 estimates a present state of the storage battery 1 being used. Next, the battery safety evaluation apparatus 2 estimates a temperature or the like of the storage battery 1 in the case of being exposed to high temperature in the state of the estimated state. The reason is that it is supposed that in view of resistance to spreading fire, the external environment of the storage battery 1 becomes high temperature in the case where another unit cell in the assembled battery has caused abnormal heat generation, firing or the like. Then, the battery safety evaluation apparatus 2 evaluates the safety of the storage battery 1 with the temperature or the like of the storage battery 1 being as an index.

As above, the battery safety evaluation apparatus 2 also estimates the state of the connected storage battery 1. Specifically, the battery safety evaluation apparatus 2 estimates inner state parameters and battery characteristics which are information regarding the state of the storage battery 1 on the basis of data on voltage and current of the storage battery 1 measured in charging/discharging the storage battery 1. The inner state parameters and the battery characteristics will be described later. In other words, the battery safety evaluation apparatus 2 is a state estimation apparatus, and a battery control apparatus.

A method for estimating the state of the storage battery 1 on the basis of the frequency of use or the number of times of use may be adopted. However, the state of a storage battery may vary depending on the use environment or a load even when the frequency of use or the number of times of use is same. Therefore, in order to estimate the state of the storage battery 1 with high accuracy, the battery safety evaluation apparatus 2 estimates the state or performance of the storage battery 1 from measurement values of charge/discharge and the like.

Notably, it is supposed that the battery safety evaluation apparatus 2 uses thermal stability data (reference data) in order to evaluate the safety. The thermal stability data will be described later. The description of details of operations of the battery safety evaluation apparatus 2 will be also given later.

The system configuration described above is an example, and the present invention is not limited to the above configuration. For example, in FIG. 1, the battery safety evaluation apparatus 2 includes the storage 24 and the thermal stability data storage 271. However, the storage 24 and the thermal stability data storage 271 may be configured into a single storage 24. In addition, the internal-resistance corrector 26 may be included in the battery characteristic estimator 25.

As long as information necessary for a process is received from the battery safety evaluation apparatus 2 and the process result is transferred to the battery safety evaluation apparatus 2 by communication or an electrical signal, the components of the battery safety evaluation apparatus 2 may be outside the battery safety evaluation apparatus 2. For example, the battery safety evaluation apparatus 2 may be separated into a battery control apparatus including the charge/discharge controller 21, a battery characteristic estimation apparatus including the measurer 22, the SOC estimator 23, the storage 24, the battery characteristic estimator 25 and the internal resistance corrector 26, and a battery safety evaluation apparatus including the battery safety evaluator 27.

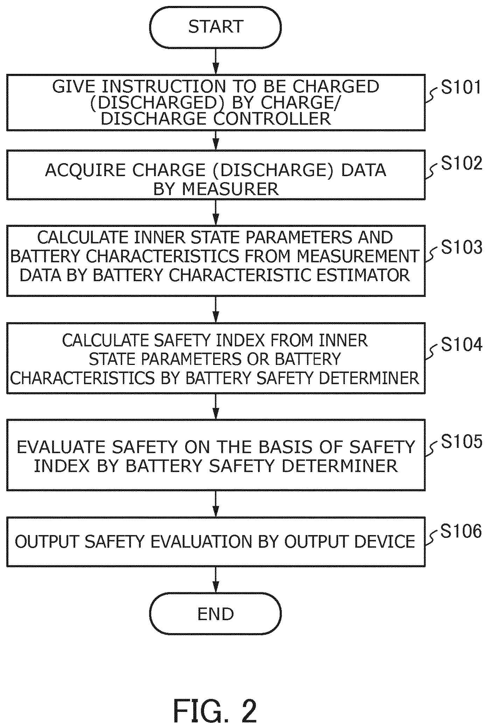

Next, an outline of processes of the battery safety evaluation apparatus 2 is described. FIG. 2 is a diagram illustrating an example of a flowchart on schematic processes of the battery safety evaluation apparatus 2. The process may be performed at every elapse of a fixed period. Otherwise, it may be performed upon reception of an instruction from a user, another system or the like through a not-shown input device.

The charge/discharge controller 21 gives the storage battery 1 an instruction to be charged (or discharged) under a predetermined condition (S101). The measurer 22 acquires the charge (discharge) data by a measurement (S102). The battery characteristic estimator 25 analyzes the charge (discharge) data (S103). Analyzing the charge result is calculating the inner state parameters and the battery characteristics (cell characteristics) of each unit cell on the basis of the charge result. More specifically, the inner state parameters are estimated on the basis of current and voltage data measured during the charge and discharge. Further, the battery characteristics are estimated on the basis of the inner state parameters.

The inner state parameters each indicate the state of a unit cell. The inner state parameters are assumed to include a positive electrode capacity (the mass of the positive electrode), a negative electrode capacity (the mass of the negative electrode), an SOC deviation, and an internal resistance. The SOC deviation means a difference between the initial charge amount of the positive electrode and the initial charge amount of the negative electrode.

The battery characteristics can be calculated from the inner state parameters, and represent characteristics including the voltage of the storage battery 1. The battery characteristics are assumed to include a battery capacity, an open circuit voltage (OCV), an OCV curve, and the like. The internal resistance may be included also in the battery characteristics. The OCV curve means a graph (a function) indicating the relationship between the open circuit voltage and a certain index regarding the storage battery. The battery capacity is within a range in which the positive electrode capacity range overlaps with the negative electrode capacity range. When the SOC is 100%, the potential difference between the positive electrode and the negative electrode is an end-of-charge voltage. When the SOC is 0%, the potential difference between the positive electrode and the negative electrode is an end-of-discharge voltage. In this way, the battery capacity can be calculated on the basis of a charge amount.

The battery safety evaluator 27 calculates an index for determining safety from the inner state parameters or the battery characteristics (cell characteristics) on the basis of thermal stability data acquired from the thermal stability data storage 271 (S104). The index is expressed as "safety index". Then, the battery safety evaluator 27 evaluates safety on the basis of the safety index (S105). The evaluation is expressed as "safety evaluation". The output device 28 outputs the safety evaluation in a manner where a user or the like can recognize it (S106). For example, it may be displayed on a display or the like. In this way, safety of the storage battery 1 can be recognized.

Notably, the safety index may be the same as the safety evaluation. In other words, the safety index may be output without safety evaluation performed. For example, when the safety index is a numerical value, if a user or the like can determine safety with the numerical value, the output device 28 may output the safety index without the process of safety evaluation (S105) performed.

Next, the components included in the battery safety evaluation apparatus 2 will be described.

The charge/discharge controller 21 gives the storage battery 1 an instruction to be charged or discharged in order to measure the inner state parameters of the storage battery 1. The charge/discharge may be performed for every fixed period or at fixed times. Otherwise, the charge/discharge may be performed upon reception, by the battery safety evaluation apparatus 2, of an instruction from a user, another system or the like through a not-shown input device.

The measurer 22 measures information about the storage battery 1. Examples of the information to be measured include the voltage between positive electrode terminals and negative electrode terminals of unit cells, current flowing through unit cells, and the temperatures of unit cells.

Data measured by the measurer 22 includes the voltage, the current, and the temperature of the storage battery 1 which are measured during charge or discharge of the storage battery 1.

The SOC estimator 23 estimates the present SOC (state of charge) of the storage battery 1 on the basis of the data measured by the measurer 22. The SOC may be estimated using an SOC-OCV curve calculated by the battery characteristic estimator 25 on the basis of the present state of the storage battery 1.

The storage 24 stores data to be used for a process according to the battery characteristic estimator 25. For example, the storage 24 stores a function showing the relationship between the charge amount and the potential of the positive electrode or the negative electrode of a unit cell. The storage 24 may store other data.

The battery characteristic estimator 25 calculates the present inner state parameters and the present battery characteristics of the storage battery 1 on the basis of the data measured by the measurer 22. The battery characteristics may not be calculated, if unneeded. As described above, the battery characteristics include a battery capacity, an internal resistance, an open circuit voltage (OCV), and an OCV curve. The OCV curve (a function) may be a function showing the relationship between the open circuit voltage (OCV) of the secondary battery and the charge state of the secondary battery or the quantity of electric charges charged in the secondary battery, for example. Alternatively, the OCV curve may be an SOC-OCV graph which illustrates the relationship between the SOC and the OCV, or may be a charge amount-OCV graph which illustrates the relationship between the charge amount and the OCV. The type of an OCV curve to be calculated may be defined in advance.

To calculate the battery characteristics, various types of a battery characteristics measurement method can be used. More specifically, the examples of the method include a charge or discharge experiment in which a battery capacity is actually measured by supplying current, a current pausing method in which an internal resistance value is mainly measured, and an electrochemical measurement such as an AC impedance measurement. Measurement may be performed by combination thereof. Alternatively, a method in which battery characteristics are simply estimated by analyzing a charge or discharge curve may be used.

The inner configuration of the battery characteristic estimator 25 is described.

The charge/discharge history recorder 251 records data (a history) of voltages, currents, and temperatures, or the like measured by the measurer 22 during charge or discharge of the storage battery 1. The recording is repeatedly performed at predetermined time intervals from start of charge/discharge of the storage battery 1 to completion of the charge/discharge. The time intervals may be freely set according to a process in which the record is to be used. For example, the time intervals may be set to approximately 0.1 to 1 second intervals. A time at which the recoding is performed may be an absolute time, or may be a relative time which is counted from start of charge/discharge. When the process performed by the charge/discharge history recorder 251 is repeated at the predetermined time intervals, recording of a time may be omitted.

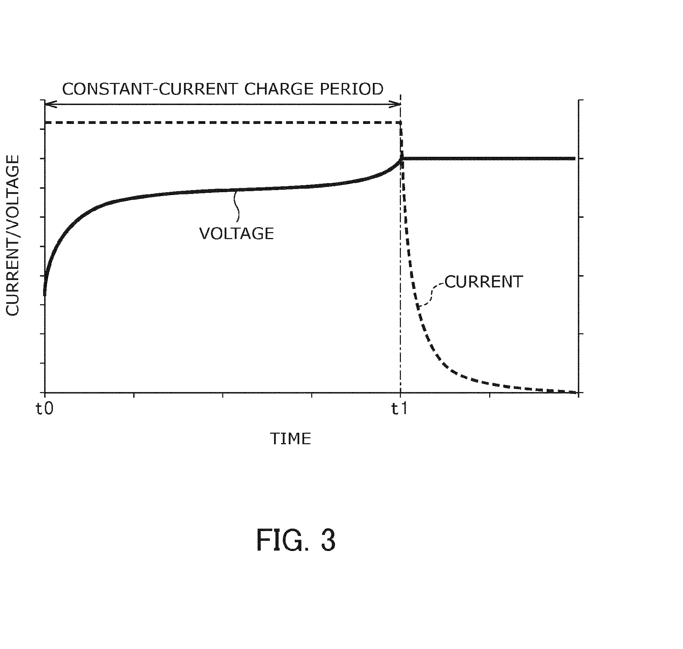

FIG. 3 illustrates an example of data regarding a current and a voltage during charge. The data illustrated in FIG. 3 is an example in constant-current constant-voltage charge, which is generally used as a charge method for secondary batteries. In FIG. 3, the broken line represents a current history and the solid line represents a voltage history.

In a process performed by the inner state parameter calculator 252, which is described later, the charge history of the whole constant-current constant-voltage charge may be used, or only the charge history of a constant-current charge period (t0 to t1 in FIG. 3) may be used, for example. Charge is not necessarily started when the SOC is 0%, and may be started when the SOC is 20%, for example.

The inner-state parameter calculator 252 calculates an amount of an active material forming the positive electrode or the negative electrode of a unit cell, an initial charge amount, the internal resistance of a unit cell, which are the inner state parameters, on the basis of the history recorded by the charge/discharge history recorder 251.

The inner state parameter calculator 252 uses a function for calculating a storage battery voltage on the basis of the active material amounts and the internal resistance. The voltage of the storage battery 1 is calculated on the basis of current data and voltage data in charging/discharging the storage battery 1 and the function. The active material amount and the internal resistance which reduce a difference between a measured voltage and the calculated voltage of the

5

storage battery 1 are obtained through regression calculation. The positive electrode may be made from a plurality of active materials. However, in the present arrangement, an example of a secondary battery having a positive electrode and a negative electrode each made from one active material is explained.

When the secondary battery having a positive electrode and a negative electrode each made from one active material is charged, a voltage (a terminal voltage) "Vt" at time "t" is expressed by the following expression.

[Expression 1]

$$V_t = f_c \left( q_0^c + \frac{q_t}{M_c} \right) - f_a \left( q_0^a + \frac{q_t}{M_a} \right) + RI_t \quad (1)$$

"$I_t$" represents a current value at time "t", and "qt" represents a charge amount of the secondary battery at time "t". "$f_c$" represents a function showing the relationship between the charge amount and the potential of the positive electrode, and "$f_a$" represents a function showing the relationship between the charge amount and the potential of the negative electrode. "$q_0{}^c$" represents the initial charge amount of the positive electrode, and "$M_c$" represents the mass of the positive electrode. "$q_0{}^a$" represents the initial charge amount of the negative electrode, and "$M_a$" represents the mass of the negative electrode. "R" represents the internal resistance.

As the current value "It", the current data recorded by the charge/discharge history recorder 251 is used.

The charge amount $q_t$ is calculated by time-integrating the current value "It". The functions "$f_c$" and "$f_a$" are assumed to be stored as function information in the storage 24.

Five values (a parameter set), the initial charge amount "$q_0{}^c$" of the positive electrode, the mass "$M_c$" of the positive electrode, the initial charge amount "$q_0{}^a$" of the negative electrode, the mass "$M_a$" of the negative electrode, and the internal resistance "R" are estimated through regression calculation. The active material amount of each of the electrodes may be calculated by regarding the amount as a predetermined ratio of the mass of the electrode.

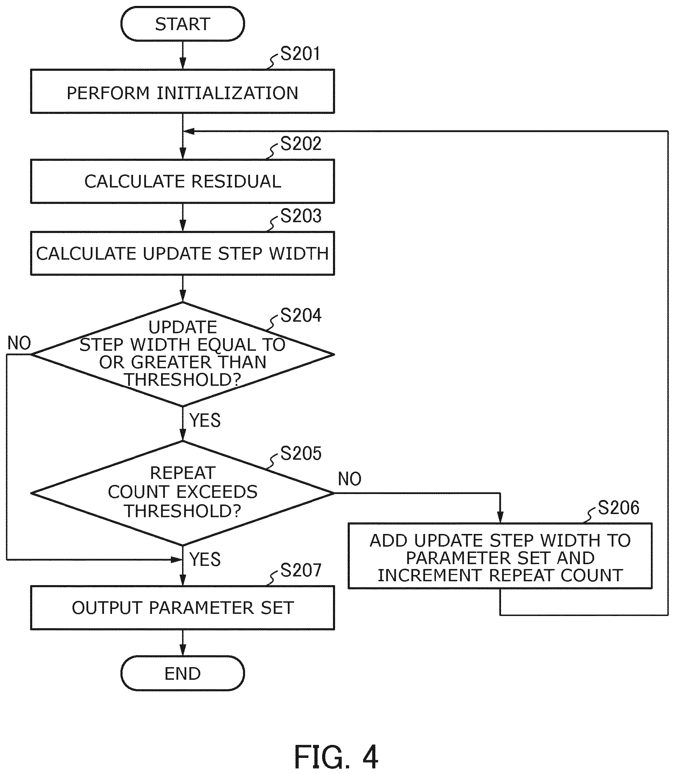

FIG. 4 illustrates an example of a flowchart of a process to be performed by the inner-state parameter calculator 252. The process to be performed by the inner-state parameter calculator 252 starts after completion of charge of the storage battery 1.

The inner-state parameter calculator 252 performs initialization to set initial values for the aforementioned parameter set and to set the repeat count of regression calculation to zero (S201). The initial value, for example, may be a value calculated when the previous process of calculating the active material amount, or may be an expectable value.

The inner-state parameter calculator 252 calculates a residual E which is expressed by the following expression (S202).

[Expression 2]

$$E = \sum_{t=0}^{t_{end}} \left( V_{bat\_t} - V_t \right)^2$$

$$= \sum_{t=0}^{t_{end}} \left( V_{bat\_t} - \left( f_c \left( q_0^c + \frac{q_t}{M_c} \right) - f_a \left( q_0^a + \frac{q_t}{M_a} \right) + RI_t \right) \right)^2 \quad (2)$$

wherein "$V_{bat\_t}$" represents the terminal voltage at time "t", and "$t_{end}$" represents a charge end time.

The inner-state parameter calculator 252 calculates an update step width of the parameter set (S203). The update step width of the parameter set can be calculated by method, such as a Gauss-Newton method, a Levenberg-marquardt method.

The inner-state parameter calculator 252 determines whether the update step width is less than a predetermined width (S204). When the update step width is less than the predetermined width (No at S204), the inner-state parameter calculator 252 determines that the calculation has converged, and outputs the present parameter set (S207). When the update step width is equal to or greater than a predetermined threshold (Yes at S204), whether the repeat count of regression calculation is greater than a predetermined value is checked (S205).

When the repeat count of regression calculation is greater than the predetermined value (Yes at S205), the present parameter set is outputted (S207). When the repeat count of regression calculation is equal to or less than the predetermined value (No at S205), the update step width calculated at S203 is added to the parameter set and the repeat count of regression calculation is incremented by one (S206). Subsequently, the process returns to calculation of the residual (S202). The flowchart illustrating the flow of the process to be performed by the inner-state parameter calculator 252 has been described above.

In the present arrangement, a charge history is used as an input to the inner-state parameter calculator 252. However, a discharge history may be used to similarly calculate an active material amount. Also in the case where a discharge history is used, the process flow to be performed by the inner-state parameter calculator 252 and parameters to be used may be same as those in the case where a charge history is used to calculate the active material amount.

The battery characteristic calculator 253 calculates an open circuit voltage which is a battery characteristic of the storage battery 1. Further, the battery characteristic calculator 253 calculates the relationship between the charge amount of the storage battery 1 and the open circuit voltage by using the initial charge amount "$q_0^c$" of the positive electrode, the mass "$M_c$" of the positive electrode, the initial charge amount "$q_0^a$" of the negative electrode, and the mass "$M_a$" of the negative electrode calculated by the inner-state parameter calculator 252.

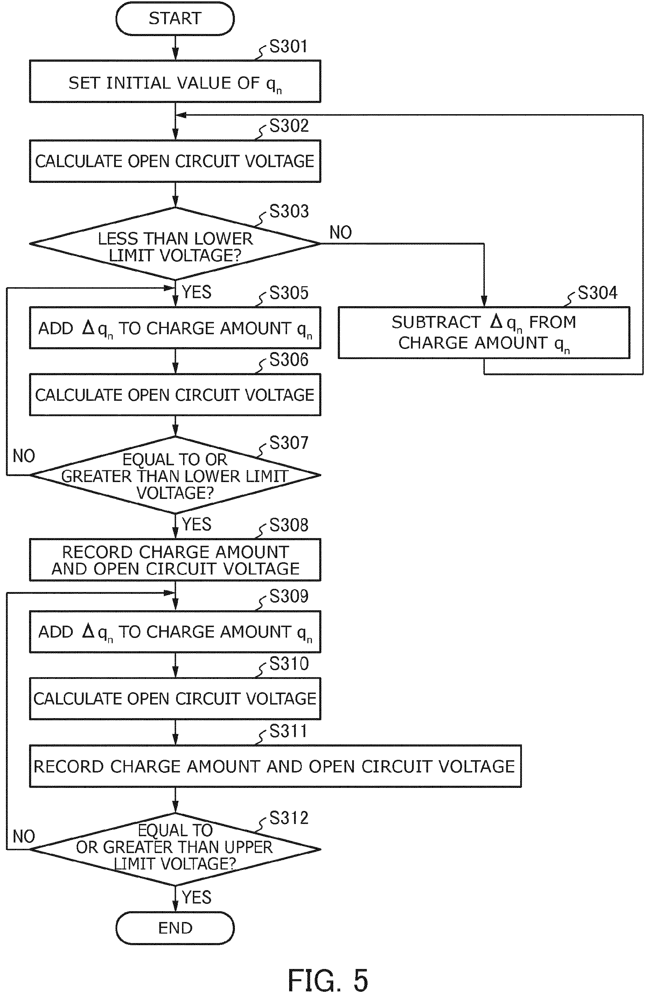

FIG. 5 illustrates an example of a flowchart of a process flow to be performed by the battery characteristic calculator 253. The flowchart starts after the process performed by the inner-state parameter calculator 252 is ended. In this flowchart, the charge amount $q_n$ is increased and decreased by a predetermined value $\Delta q_n$, the charge amount $q_{n0}$ is found at which the open circuit voltage exceeds the lower limit, and $q_n$ is increased by $\Delta q_n$ from $q_{n0}$ as an initial value until the open circuit voltage exceeds the upper limit, and the charge amount and the open circuit voltage are recorded every time the increase is performed. Accordingly, the relationship between the charge amount and the open circuit voltage in a range from the lower limit to the upper limit of the open circuit voltage can be calculated. The difference between the charge amount $q_{n0}$ and the charge amount $q_n$ at which the open circuit voltage is the upper limit is a battery capacity.

The battery characteristic calculator 253 sets the initial value of the charge amount $q_n$ (S301). The initial value of $q_n$ may be set to zero or to a value which is less than zero by a few percent of the nominal capacity of the storage battery 1. Specifically, if the nominal capacity of the storage battery 1 is 1000 mAh, the initial value of $q_n$ may be set within a range of approximately -50 mAh to 0 mAh.

The battery characteristic calculator 253 calculates the open circuit voltage (S302). To calculate the open circuit voltage, the following expression can be used.

[Expression 3]

$$E_n = f_c\left(q_0^c + \frac{q_n}{M_c}\right) - f_a\left(q_0^a + \frac{q_n}{M_a}\right) \ (3)$$

Next, the battery characteristic calculator 253 compares the calculated open circuit voltage with a predetermined storage battery lower limit voltage (S303). The storage battery lower limit voltage is defined on the basis of combination of the positive electrode active material and the negative electrode active material used in the storage battery 1. Specifically, in terms of each of the safety, the lifetime, the resistance, or the like, the appropriate usage ranges of the voltage for the positive electrode active material and the negative electrode active material are defined, and the combination of the ranges is used to determine the lower limit and the upper limit of the usage range for the storage battery.

When the open circuit voltage is not less than the predetermined lower limit voltage (No at S303), $\Delta q_n$ is subtracted from the charge amount $q_n$ (S304) and the open circuit voltage is calculated again (S302). When the open circuit voltage is less than the predetermined lower limit voltage (Yes at S303), the battery characteristic calculator 253 adds $\Delta q_n$ to the charge amount $q_n$ (S305). In this way, the charge amount $q_n$ approximates to the lower limit value. A value of $\Delta q_n$, can be freely determined. For example, $\Delta q_n$ may be set to approximately 1/1000 to 1/100 of the nominal capacity of the storage battery 1. Specifically, if the nominal capacity of the storage battery 1 is 1000 mAh, $\Delta q_n$, may be set to a range of approximately 1 mAh to 10 mAh.

The battery characteristic calculator 253 calculates the open circuit voltage by using the added charge amount $q_n$ + $\Delta q_n$ (S306). Subsequently, the battery characteristic calculator 253 compares the calculated open circuit voltage with the aforementioned lower limit voltage (S307). When the open circuit voltage is lower than the lower limit voltage (No at S307), the process returns to S305 and $\Delta q_n$ is added to the charge amount $q_n$ again (S305). When the open circuit voltage is equal to or higher than the lower limit voltage (Yes at S307), the charge amount $q_n$ at that time is set to $q_{n0}$ because the open circuit voltage has exceeded the lower limit value, and the charge amount $q_{n0}$ and the open circuit voltage En are recorded together (S308). The value of the charge amount $q_{n0}$ may be set as a reference value and expressed by "0". In this case, the value obtained by subtracting the value of $q_{n0}$ from the value of the charge amount $q_n$, in subsequent recording.

The battery characteristic calculator 253 adds $\Delta q_n$ to the charge amount $q_n$ (S309), calculates the open circuit voltage (S310), and records the calculated open circuit voltage En and the value obtained by subtracting $q_{n0}$ from the charge amount $q_n$ (S311).

The battery characteristic calculator 253 compares the calculated open circuit voltage with the predetermined upper limit voltage of the storage battery 1 (S312). The upper limit voltage of the storage battery 1 is defined on the basis of combination of the positive electrode active material and the negative electrode active material used in the storage battery 1. When the open circuit voltage is lower than the predetermined upper limit voltage (No at S312), the process returns to adding of $\Delta q_n$ to the charge amount again (S309). When the open circuit voltage is equal to or higher than the predetermined upper limit voltage (Yes at S312), the process is ended. The flowchart illustrating the process flow to be performed by the battery characteristic calculator 253 has been described.

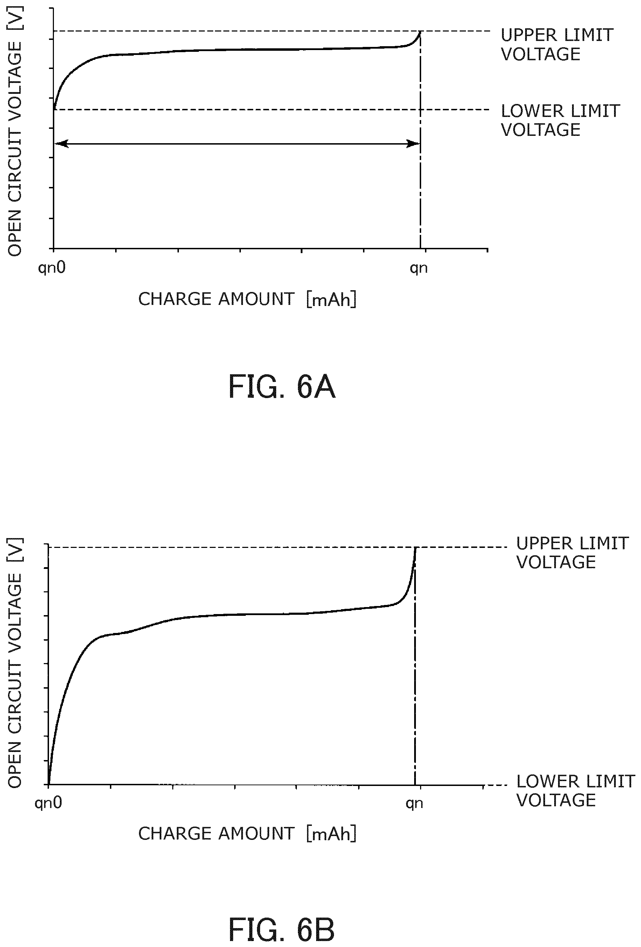

FIG. 6A and 6B illustrate an example of graphs (charge amount-OCV curves) illustrating the relationships between a charge amount and an open circuit voltage. FIG. 6A illustrates a charge amount-OCV curve at the present state obtained by the battery characteristic calculator 253. FIG. 6B is a diagram obtained by taking out a range from the lower limit voltage to the upper limit voltage of the ordinate, from the graph illustrated in FIG. 6A.

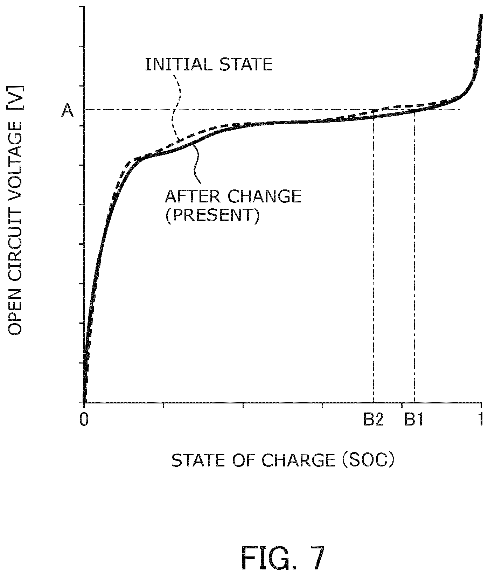

FIG. 7 illustrates an example of a graph (an SOC-OCV curve) illustrating the relationship between an SOC and an open circuit voltage. FIG. 7 differs from FIG. 6A and 6B in that the abscissa in FIG. 7 indicates not the charge amount but the SOC. In FIG. 7, a graph (a solid line) obtained by converting the graph illustrated in FIG. 6B into a SOC-OCV curve and the SOC-OCV curve (a broken line) of the storage battery at the initial state are overlapped. In FIG. 7, the broken line represents the open circuit voltage of the storage battery at the initial state, and the solid line represents the open circuit voltage of the storage battery after change (present time) due to deterioration of the storage battery or the like. The SOC indicates the ratio of the present charge amount with respect to the full charge capacity, and is expressed by a value from 0 to 1, or 0 to 100%.

The charge amount may be converted into an SOC by using the battery capacity and the charge amount calculated from the charge amount-OCV curve. In the description herein, the simple term "charge state" includes not only the SOC but also the charge amount and the like.

The length of the curve after change becomes shorter as the capacity decreases. However, FIG. 7 illustrates that not only the length but also the shape of the curve changes. For example, in the case where the state of charge (SOC) is estimated on the basis of the open circuit voltage, when the measured open circuit voltage is A, the normal charge state (the present state of charge) is B1. However, if the curve of the open circuit voltage is considered not to change, that is, if the open circuit voltage is to be obtained from the SOC-OCV curve at the initial state, B2 is obtained as the charge state at the voltage A, and thus, efficiency in estimation of the charge state is deteriorated. Therefore, as a result of using the SOC-OCV curve at the present state, as in the first arrangement, the charge state can be measured with high accuracy.

The SOC-OCV curve calculated by the battery characteristic estimator 25 may be acquired by the SOC estimator 23 such that the SOC estimator 23 estimates the SOC of the storage battery 1 on the basis of the SOC-OCV curve.

Therefore, according to the first arrangement, it is possible to accurately grasp the relationship (the charge amount-OCV curve or the SOC-OCV curve) which changes with use between the charge amount and the open circuit voltage, without performing special charge and discharge, and thus, the charge state can be highly accurately estimated.

The case where the positive electrode and the negative electrode of the secondary battery are each formed from one kind of an active material has been described herein. However, the present invention can be similarly applied to a secondary battery in which any of the positive electrode and the negative electrode thereof is formed from a plurality of kinds of active materials. Further, in the case where a different storage 24 for storing the active material amounts of the storage battery 1 is prepared in advance, the battery characteristic calculator 253 can calculate a graph showing the relationship between the charge amount and the open circuit voltage of the secondary battery within a predetermined voltage range of the storage battery 1, by using the active material amounts stored in the different storage 24.

The battery characteristic calculator 253 may further calculate other battery characteristics. For example, the battery characteristic calculator 253 may calculate the voltage, the power, and the power amount of the storage battery 1 by using the calculated open circuit voltage or the like. As the calculation method, for example, calculation expressions below may be used. In the following calculation expressions, "c" represents a predetermined constant.

(Voltage)

$$\text{voltage} = \text{open circuit voltage} - c \times \text{internal resistance} \times \text{current}$$

(Power)

$$\text{power} = \text{current} \times \text{open circuit voltage} - c \times \text{internal resistance} \times (\text{current})^2$$

(Power amount)

$$\text{power amount} = \text{battery capacity} \times \text{average voltage}$$

As the internal resistance, an estimated value calculated by the inner-state parameter calculator 252 may be used, or an estimated value corrected by the internal-resistance corrector 26 may be used. The internal-resistance corrector 26 will be described later. The battery characteristic calculator 253 may recalculate a battery characteristic, which has been calculated, by using the estimation value corrected by the internal-resistance corrector 26. The estimation value corrected by the internal-resistance corrector 26 can further improve the accuracy. The current may be acquired from data measured by the measurer 22. The battery characteristic calculator 253 may receive an expression, a constant value, or the like necessary for the calculation, via the storage 24 or the like.

The internal-resistance corrector 26 corrects, on the basis of a temperature T measured by the measurer 22, the internal resistance R calculated by the battery characteristic estimator 25 to the internal resistance of the storage battery 1 at the present temperature T. The corrected internal resistance is defined as Rcr. In a case where the internal resistance is not corrected, the internal-resistance corrector 26 can be omitted.

Temperature correction of the internal resistance is performed by the internal resistance corrector 26, will be described. The temperature correction of the internal resistance provides, for example, correction of influence of the temperature with respect to a storage battery performance diagnosis method, and expands a temperature range within which storage battery performance diagnosis can be excellently applied. In a battery characteristics diagnosis method, as described in the processing of the battery characteristic estimator 25, the battery capacity, the internal resistance, and the degree of degradation of each of the active materials of each of the positive and negative electrodes are estimated from the charge and discharge curve by reference to the charge amount - OCV data of each of the active materials.

The principle and method of the temperature correction are described. Lithium-ion secondary batteries each include a positive electrode and a negative electrode opposite to each other, and an electrolyte containing a Li salt between the positive and negative electrodes. Active materials are applied onto current collecting foils of the positive and negative electrodes. The current collecting foils are connected to the positive electrode and negative electrode terminals on the storage battery exterior. During charge and discharge of the storage battery 1, Li ions move between the positive electrode active material and the negative electrode active material via the electrolyte so that electrons flow from the active materials to external terminals.

Each of the active materials has a unique potential and a unique amount of Li which can be reversibly inserted or desorbed. An energy quantity which the storage battery 1 can store in a range of a fixed charge and discharge voltage is determined by the amounts of the positive electrode active material and the negative electrode active material in the storage battery 1 and combination thereof.

Further, at the time of charge and discharge, there are caused Li ion conduction, charge transfer resistance due to Li ions in the electrolyte penetrating into the active material, resistance of a film formed on the interface between the electrolyte and the active material, and electrical resistance due to electrons flowing through the active material and the current collection foil. The internal resistance of the storage battery 1 is the sum total of the Li ion transfer resistance, the electron transfer resistance, the charge transfer resistance, the film resistance, and the diffused resistor in the positive electrode and the negative electrode.

Generally, in a storage battery control system in a lithium ion secondary battery, the voltage of each of the unit cells, the temperature in the group battery, and the like, are measured in the viewpoint of safety. If the battery characteristics can be calculated on the basis of such measurement data, cost and time required for calculation can be suppressed.

However, it is very difficult to analyze the behavior of the storage battery during actual use in which a charge and discharge condition finely and randomly varies. The reason for this is that since such a behavior is a phenomenon in which a resistance depending on time, a diffusion resistance, a relaxation process, and the like are complexed in a complicated way, a calculation model therefor is difficult to obtain. In contrast, for example, if only a simply behavior such as charge of an electric vehicle under a predetermined condition is analyzed, the analysis can be performed using a simplified model.

Therefore, in the storage battery performance estimating method according to the present arrangement, values of variables are determined by fitting calculation using, as variables, the amount of each of the active materials, the rise (overvoltage) of the storage battery voltage due to internal resistance at application of charge current, on the basis of an "electric potential - charge amount" curve associated with the Li insertion-elimination reaction of each active material, which is obtained by data (charge-discharge curve) of charge or discharge under fixed conditions. Thereby, it is possible to estimate the capacity reduction (reduction of each active material) and the increase in internal resistance.

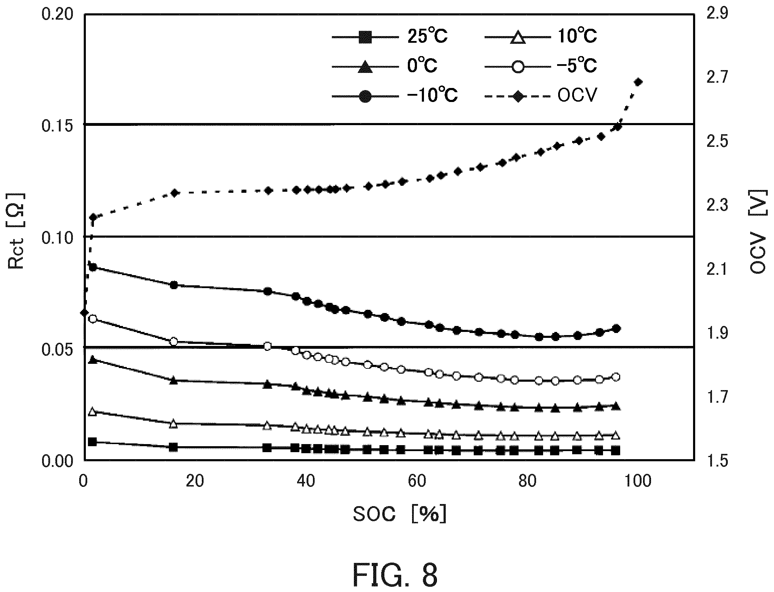

However, under an actual use situation of a storage battery, a temperature condition varies according to an external environment, the state of the storage battery during charge and the like. When the temperature of the storage battery changes, the performance of the storage battery changes. In particular, the internal resistance increases greatly depending on reduction in temperature. FIG. 8 illustrates an example of the relationships, at respective temperatures, between SOCs and reaction resistances Rct. A reaction resistance Rct is one of internal resistance components. As illustrated in FIG. 8, reaction resistances differ greatly according to difference in temperature. Accordingly, even if the analysis results of measurement data of different temperatures are compared with one another, it is difficult to evaluate the increase in internal resistance due to deterioration because the results are greatly influenced by variation in analysis result caused by temperatures.

Accordingly, when the battery characteristics are estimated on the basis of measurement data about the storage battery actually being used, performing temperature correction on the internal resistance improves accuracy of estimating the battery characteristics.

Internal resistances of the storage battery are composed of a plurality of types of resistance components. The resistance components differ from one another in temperature dependency and increase speed due to deterioration. For this reason, with progress of deterioration, the ratio of the resistance changes, and accordingly, the temperature dependency of the internal resistance as a whole also changes. In view of this point, in temperature correction of internal resistances in the storage battery performance estimating method according to the present arrangement, internal resistances are divided into three components, which are a reaction resistance "Rct", a diffusion resistance "Rd", and an ohmic resistance "Rohm". The components are corrected to values corresponding to a reference temperature "T0", in accordance with the respective unique temperature dependencies, and then, are summed up.

Specifically, the storage battery temperature at the time of measurement is corrected to the reference temperature by mathematical expressions below. In the expressions below, "Rgas" represents a gas constant, "T0" represents the reference temperature, T represents the storage battery temperature at the time of measurement, "R1" represents a constant, and "Ea", "Eb", and "Ec" each represent a constant for determining the temperature dependency of the corresponding resistance component.

(Reaction resistance)

$$Rct(T0) = Rct(T) \times Exp(-Ea/(Rgas \cdot T))/Exp(-Ea/(Rgas \cdot T0))$$

(Diffusion resistance)

$$Rd(T0) = Rd(T) \times Exp(-Eb/(Rgas \cdot T))/Exp(-Eb/(Rgas \cdot T0))$$

(Ohmic resistance)

$$Rohm(T0) = (Rohm(T) - R1) \times Exp(-Ec/(Rgas \cdot T))/Exp(-Ec/(Rgas \cdot T0)) + R1$$

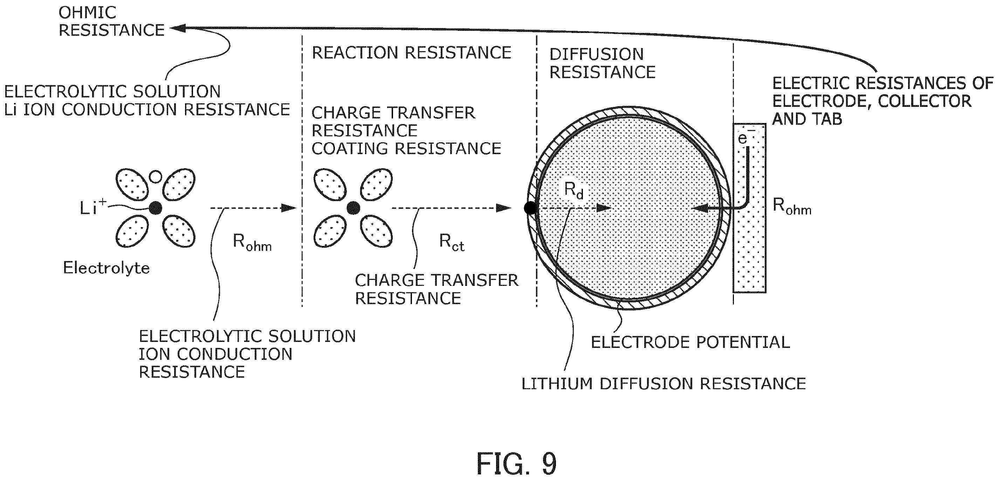

FIG. 9 is a diagram regarding the resistance components. The ohmic resistances include an ion conduction resistance in an electrolyte and an electron conduction resistance in the storage battery. The electron conduction resistance which has a low temperature dependency is a constant. The reaction resistances include a charge transfer resistance and the resistance of a surface coating. The diffusion resistances include resistances associated with diffusion of lithium ions inside the active materials and the electrodes.

"Ec" of the ohmic resistance represents an active energy associated with transfer of Li ions in the electrolyte. "Ea" of the reaction resistance represents an energy generated when Li ions solvated in the electrolyte are removed on an active material surface. "Eb" of the diffusion resistance is considered as an active energy associated with transfer of Li ions between sites in an active material. Accordingly, the above values can be considered as constant values which are not changed in the deterioration process.

The values "Ea", "Eb", and "Ec" can be calculated by measuring the AC impedances, or the current pulses of unit cells, for example. The values "Ea", "Eb", and "Ec" about the storage battery to be analyzed are calculated from measurement values, and stored in the storage 24, in advance. The values may be referred in temperature correction calculation of the internal resistances.

A method of estimating the battery characteristics from the charge and discharge curve by dividing the internal resistances into three types of components is described.

In the deterioration process of the storage battery, all of the three components of the internal resistances increase, but the increase speeds due to the deterioration differ from one another. Accordingly, the assumption that deterioration does not occur may be established as a result of limiting the lifetime range of the storage battery to be evaluated. For example, in a storage battery for electric vehicles for which the evaluation lower limit is assumed to be the residual capacity of approximately 90 to 70%, some of the resistance components can be approximated to a fixed value throughout the storage battery lifetime, although the use condition, the configuration of the storage battery, and the like can have some influences.

(First Method)

In a first method for calculating the three components from the calculated internal resistance values of the storage battery, the ohmic resistance component and the diffusion resistance component are considered to be fixed, and the residual is considered as the reaction resistance. This method assumes that deterioration does not cause increase in the ohmic resistance component and the diffusion resistance component, and considers only temperature change which depends on a cell temperature. In analysis of a charge and discharge curve, the ohmic resistance component and the diffusion resistance component at the temperature T are subtracted from the internal resistance value estimated for the temperature T, and the remainder is regarded as the reaction resistance component. The components are subjected to temperature correction to the reference temperature T0, and summed up, so that the internal resistance values at the reference temperature T0 are calculated. The first method is suitable for moderate usage, in which, for example, the SOC falls within a range in which the active materials of the positive and negative electrodes are stable, the temperature is equal to or lower than the approximate room temperature, and the current of the storage battery is relatively small.

(Second Method)

In a second method, the ohmic resistance component and the diffusion resistance component are estimated by a function regarding the relationship between the two resistance components and an accumulated time or accumulated power amount, and the residual is regarded as the reaction resistance. This method calculates the ohmic resistance component and the diffusion resistance component, while assuming that deterioration in the ohmic resistance component and the diffusion resistance component correlates with a time or a cycle amount of charge and discharge. In analysis of a charge and discharge curve, the calculated ohmic resistance component and the calculated diffusion resistance component are subtracted from the internal resistance value estimated for the certain temperature T, and the remainder is regarded as the reaction resistance component. The components are subjected to temperature correction to the reference temperature T0, and summed up, so that the internal resistance values at the reference temperature T0 are calculated. The second method is suitable for a case where deterioration in the ohmic resistance component and the diffusion resistance component is relatively small, but actually progresses.

Which of an accumulated time and an accumulated power amount is used may be determined according to the use environment or the like. For example, for a case where deterioration of the storage battery progresses due to generation of gas during preservation, deterioration amount estimation using an accumulated time is suitable. In contrast, for a case where deterioration of the storage battery, such as change in volume of the active materials, is remarkable due to repetition of a process cycle such as charge and discharge, deterioration amount estimation using an accumulated power amount is suitable.

Data on an accumulated time or an accumulated power amount is assumed to be held in advance. The accumulated power amount may be replaced with an operation amount of a device, such as the travel distance of a vehicle, for example.

(Third Method)

In a third method, a reaction resistance component and a diffusion resistance component are estimated from data on the diffusion resistances and the charge amounts of the respective materials which are held in advance or data on the reaction resistances and the charge amounts of the respective materials which are held in advance, and the residual is regarded as an ohmic resistance component. In the third method, unlike the first and second methods, the values of the reaction resistance and the diffusion resistance are estimated by performing regression calculation, in analysis of the charge and discharge curve, with reference to the reaction resistance-charge amount curve of an active material, the diffusion resistance-charge amount curve of an active material, or the internal resistance-charge amount curve of the storage battery. By using the fact that the resistance component of an active material has a dependency on the charge amount, that is, the SOC, and that the tendency of the dependency does not change even after deterioration, the compositions of the internal resistance are estimated from the tendency of internal resistance-charge amount of the storage battery.

A reaction resistance-charge amount curve and a diffusion resistance-charge amount curve of an active material need to be measured in advance. The form of change due to deterioration, which depends on the configuration of the storage battery, needs to be measured in advance. For example, it is considered that, when a resistive surface film is formed, the resistance is uniformly increased by a constant value according to the formation of the film, and that, when the active material is decreased, the resistance is uniformly increased by n-times according to the decrease.

The third method is suitable for a case where the reaction resistance-charge amount remarkably changes, and as a result, the reaction resistances of the storage battery clearly have a dependency on the charge amount.

(Fourth Method)

In a fourth method, regression calculation is performed using data of each active material which is held in advance and is on the diffusion resistance-charge amount, the reaction resistance-charge amount, and the ohmic resistance-charge amount, so that the reaction resistance component, the ohmic resistance component, and the diffusion resistance component are estimated. In the third method, only the diffusion resistance-charge amount and the reaction resistance-charge amount are used. However, in the fourth method, data on the ohmic resistance-charge amount is further used. The fourth method is effective for a case where the dependency of an active material on the ohmic resistance-charge amount is characteristic, for example, a case where the electron conductivity of the active material greatly changes due to charge or discharge.

The battery characteristic calculator 253 may calculate, as the battery characteristics, the power amount or the like which can be actually outputted by using the corrected internal resistances. The power amount which can be actually outputted can be calculated on the basis of the charge amount-OCV curve, the dischargeable power amount, and the corrected internal resistances.

The battery safety evaluator 27 estimates a heat amount upon heat generation by the storage battery 1 from the present inner state parameters or battery characteristics estimated by the battery characteristic estimator 25, and estimates a temperature of the storage battery 1 due to the heat amount. Then, the battery safety evaluator 27 evaluates safety of the storage battery 1 on the basis of the temperature of the storage battery 1. Details thereof will be described with description of the components of the battery safety evaluator 27.

By using the present inner state parameters or battery characteristics, safety in accordance with the present inner state (deterioration state) of the storage battery 1 can be evaluated. It should be noted that the same deterioration states give different safeties depending on the SOC of the storage battery 1. Specifically, a higher SOC causes a higher risk of firing. Therefore, it is supposed that the battery safety evaluator 27 evaluates safety of the storage battery 1 at a specific value of the SOC. For example, safety at the present SOC estimated by the SOC estimator 23 may be evaluated. For example, safety at 100% of SOC (full charge) of the storage battery 1 may be evaluated. Moreover, when an SOC range is defined to the storage battery 1 as a condition of use, safety in the state of the upper limit of the SOC range may be evaluated. In view of safety, safety is preferably evaluated in the state where a risk of firing is higher, in other words, in the case where the SOC is larger.

The thermal stability data storage 271 stores thermal stability data needed in calculating safety of the storage battery 1. Notably, the thermal stability data storage 271 may store data other than the thermal stability data. For example, the thermal stability data storage 271 may store a specific heat of the storage battery 1, a heat transfer coefficient in radiating calories from the storage battery 1 to an external environment, and the similar values for performing a process regarding the safety index calculator 274. In addition to the above, the thermal stability data storage 271 may store constraint conditions used for the processes of the battery safety evaluator 27 and the similar conditions. For example, the thermal stability data storage 271 may store the SOC range applied to the storage battery 1 as a condition of use, and may store calculated safety indices and the like.

The thermal stability data is data regarding heat generation of a secondary battery in the case where the secondary battery is exposed to high temperature. The thermal stability data at least indicates relationship between a heat amount of the secondary battery and an external temperature. For example, the thermal stability data may be a DSC curve measured by a differential scanning calorimeter (DSC). Notably, the external temperature means a temperature of an external environment of the secondary battery, and may be a temperature of an adjacent cell or a temperature of a surrounding space.

Notably, the thermal stability data is categorized for values of the SOC. For example, when safety of a storage battery 1 in the state of 100% of SOC is evaluated, thermal stability data at 100% of SOC is used. Heat generation behavior of the secondary battery varies in accordance with the value of the SOC.

Moreover, thermal stability data in accordance with the state of a secondary battery other than the SOC may be included. For example, thermal stability data regarding an unused secondary battery may be included. Moreover, thermal stability data for a secondary battery in the state where metal (lithium in the case of a lithium ion secondary battery) is deposited due to deterioration may be included.

The thermal stability data may be expressed as a graph or a function. For example, the thermal stability data may be a graph indicating relationship between the external temperature of a secondary battery and the heat amount of the secondary battery. Moreover, an approximation function of the graph may be used as the thermal stability data.

It is supposed that the thermal stability data is categorized for electrodes of a secondary battery. In other words, the thermal stability data may include thermal stability data regarding the positive electrode of a secondary battery and thermal stability data regarding the negative electrode of the secondary battery.

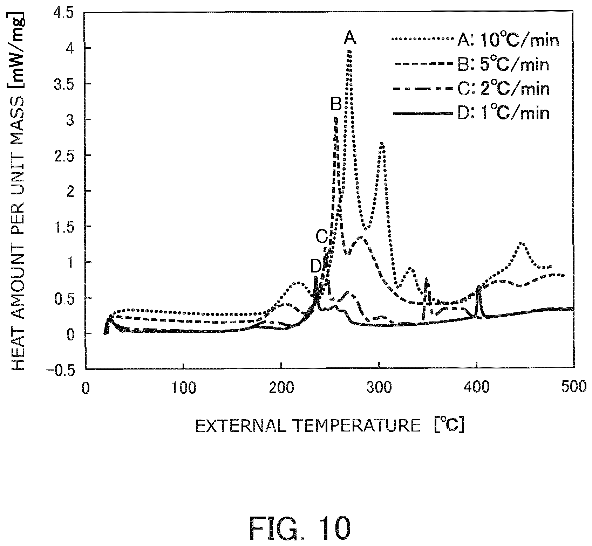

FIG. 10 is a diagram illustrating an example of the thermal stability data. FIG. 10 illustrates a graph obtained by plotting the thermal stability data. The graph regarding the thermal stability data as illustrated in FIG. 10 is expressed as "heat amount calculation graph". The ordinate represents a heat amount per mass. The abscissa represents an external temperature. The heat amount calculation graph in FIG. 10 illustrates DSC curves. As illustrated in FIG. 10, the thermal stability data includes the heat amount per mass, a heat generation start temperature and the like. Notably, a mass in the heat amount per mass means the sum total of the mass of the positive electrode or the negative electrode and the mass of the electrolytic solution. Moreover, data in FIG. 10 shows a graph based on data of the positive electrode of a secondary battery measured at 100% of SOC. As above, the thermal stability data exists for each electrode and for each value of the SOC.

A secondary battery gives much heat amount at an external temperature at a peak in a DSC curve. Namely, this external temperature at the peak is a thermal runaway temperature. Notably, in the four graphs in FIG. 10, temperature elevating speeds of the external temperature are different from one another. The graph A presents a case where the external temperature is elevated at 10°C per minute, the graph B presents a case where the external temperature is elevated at 5°C per minute, the graph C presents a case where the external temperature is elevated at 2°C per minute, and the graph D presents a case where the external temperature is elevated at 1°C per minute. As above, timing and the like of the heat amount and the thermal runaway vary also depending on the temperature elevating speed. The temperature elevating speed of the external temperature may be designated in accordance with desired safety, a configuration of the storage battery 1, a surrounding environment, and the like.

The thermal stability data is created on the basis of measurement data of a plurality of secondary batteries. The plurality of secondary batteries used for creating the thermal stability data are adopted as secondary batteries which satisfy certain prerequisite conditions. The thermal stability data is generally used for other secondary batteries which satisfy the prerequisite conditions.

The prerequisite conditions are not specially limited but may be various prerequisite conditions. For example, there may be prerequisite conditions of materials used for electrodes of a secondary battery, prerequisite conditions that active material amounts of electrodes are within predetermined ranges, and the similar prerequisite conditions. Then, the plurality of secondary batteries which satisfy the prerequisite conditions are inspected, and on the basis of the inspection results, the thermal stability data is calculated. Notably, a method for creating the thermal stability data is not specially limited but may be arbitrarily defined.

Otherwise, an unused state, a state where metal is deposited, and the similar state may be regarded as prerequisite conditions. Alternatively, a matter regarding a preservation or use environment of a secondary battery may be regarded as a prerequisite condition. As a prerequisite condition regarding the environment, the temperature, the humidity, or the like may be used. For example, also a matter regarding the use history of a secondary battery may be used as a prerequisite condition. As a prerequisite condition regarding the use history, the number of performing charge and discharge, the total use time, or the like may be used.

As the causes of deterioration of a secondary battery, the reactivity with an electrolyte, a damage due to expansion or contraction of an active material or the like may be expected. However, specifying the cause of deterioration of a secondary battery is difficult. The deterioration condition varies according to the storage condition, the use history, or the like of a secondary battery. Therefore, thermal stability data is beforehand calculated for each of various prerequisite conditions, and the thermal stability data matching the state of the storage battery 1 is used. In other words, the thermal stability data calculated on the basis of the inspection result of a secondary battery in the similar state to the state of the storage battery 1 is used. Thereby, the heat amount of the storage battery 1 can be estimated with excellent accuracy.

The thermal stability data acquirer 272 acquires the estimation value regarding at least any of the inner state parameter and the battery characteristic from the battery characteristic estimator 25. Then, the thermal stability data acquirer 272 acquires thermal stability data (first reference data) corresponding to the storage battery 1 from the thermal stability data storage 271 at least on the basis of the acquired estimation value. In other words, the thermal stability data acquirer 272 extracts the thermal stability data corresponding to the storage battery 1 out of the thermal stability data of secondary batteries.

Notably, it is supposed that the thermal stability data corresponding to the storage battery 1 includes thermal stability data corresponding to the positive electrode of the storage battery 1 and thermal stability data corresponding to the negative electrode of the storage battery 1. In other words, the thermal stability data acquirer 272 may acquire the thermal stability data corresponding to the positive electrode on the basis of the estimation value regarding the positive electrode, and may acquire the thermal stability data corresponding to the negative electrode on the basis of the estimation value regarding the negative electrode. For example, the thermal stability data may be acquired on the basis of the initial charge amount of the positive electrode or the negative electrode calculated as an inner state parameter. For example, the thermal stability data may be acquired on the basis of the mass of the positive electrode or the negative electrode calculated as an inner state parameter. For example, the thermal stability data may be acquired on the basis of the open circuit voltage calculated as a battery characteristic.

When the estimation value of the storage battery 1 satisfies the prerequisite condition of a secondary battery in the occasion of beforehand creating the thermal stability data, the relevant thermal stability data can be regarded as corresponding to the storage battery 1. For example, in the case where the thermal stability data has been created on the basis of a plurality of secondary batteries satisfying a prerequisite condition that the active material amount of the positive electrode is within a predetermined range, when the estimation value on the active material amount of the positive electrode of the storage battery 1 is within the predetermined range, the relevant thermal stability data can be regarded as corresponding to the storage battery 1. Moreover, the thermal stability data corresponding to the storage battery 1 can also be regarded as thermal stability data suitable for estimating the heat amount of the storage battery 1.

Notably, as mentioned above, the thermal stability data is categorized for values of the SOC. Therefore, the thermal stability data acquirer 272 acquires the thermal stability data matching a specified value of the SOC out of the thermal stability data corresponding to the storage battery 1.

Notably, the thermal stability data acquirer 272 may acquire the thermal stability data on the basis of a plurality of estimation values. Thermal stability data matching a plurality of estimation values is highly possibly thermal stability data more matching the storage battery 1 than thermal stability data matching one estimation value. Therefore, in the case of using the thermal stability data matching a plurality of estimation values, the accuracy of the calculated safety index and safety evaluation is considered to be improved more than in the case of using the thermal stability data matching one estimation value.

The heat amount estimator 273 calculates the heat amount of the storage battery 1 on the basis of the thermal stability data (first reference data) which is acquired by the thermal stability data acquirer 272 and is set to corresponding to the storage battery 1.

Notably, the heat amount estimator 273 may calculate the heat amount of the positive electrode of the storage battery 1 on the basis of the thermal stability data set to correspond to the positive electrode of the storage battery 1, and may calculate the heat amount of the negative electrode of the storage battery 1 on the basis of the thermal stability data set to correspond to the negative electrode of the storage battery 1. Then, the sum of the heat amounts on the positive electrode and the negative electrode of the storage battery 1 may be set to the heat amount of the storage battery 1. Otherwise, only the heat amount of the positive electrode or the negative electrode may be used as the heat amount of the storage battery 1.

For example, a case of estimating a heat amount, for example, using the heat amount calculation graph illustrated in FIG. 10 is described. The heat amount estimator 273 obtains the area of a peak portion included in a predetermined range of the external temperature. Since a heat amount is indicated as the area of a peak portion in a DSC curve, it is obtained as an integration value on a heat amount calculation graph within a time range of the peak (from the heat generation start temperature to the heat generation end temperature). The heat generation start temperature, that is, the start point of the peak may be set to a temperature at which the slope of the DSC curve exceeds a threshold (rising temperature of the peak). Otherwise, it may be set to a temperature at the intersection of the tangential line of the peak and the baseline. The end point of the peak, that is, the heat generation end temperature may be obtained similarly to the heat generation start temperature. In this way, the heat amount is obtained from the thermal stability data.

The predetermined range of the external temperature may be arbitrarily defined. Note that when evaluating safety of a cell in the case where an adjacent cell fires, it is preferable that the external temperature is set close to a temperature to which the cell is assumed to be exposed in the case where the adjacent cell fires in order to perform effective evaluation. In this way, the heat amount of the storage battery 1 in the occasion when the external temperature changes within the predetermined range is obtained.

Notably, the heat amount estimator may predefine a threshold (thermal runaway determination threshold) for determining whether or not thermal runaway arises, and may determine that thermal runaway is to arise when the heat amount per unit mass exceeds the thermal runaway determination threshold.

Notably, to obtain the heat amount every time from the heat amount calculation graph as above causes load and takes time. Therefore, data in which the inner state parameters or the battery characteristics are associated with the heat amount and the like may be used. In other words, the thermal stability data may be data (association table) indicating association between the inner state parameters or the battery characteristics and the items in the thermal stability data. The table may be created by an external device, or may be created by the battery safety evaluator 27 on the basis of the past process history.

When the thermal stability data is an association table, the heat amount estimator 273 may refer to the table when acquiring the inner state parameters or the like to extract the heat amount and the like corresponding to the acquired inner state parameters.

The safety index calculator 274 calculates a temperature of the storage battery 1 in the occasion when the external temperature changes within the predetermined range on the basis of the estimated heat amount of the storage battery 1. The calculated temperature of the storage battery 1 is expressed as "end-point cell temperature".

A temperature change of the storage battery 1 is obtained by dividing the difference obtained by subtracting calories (radiation amount) radiated from the storage battery 1 to the external environment from the heat amount of the storage battery 1 by the specific heat of the storage battery 1. The radiation amount is obtained by multiplying the difference obtained by subtracting the external temperature from the temperature of the storage battery 1 by a heat transfer coefficient. The heat transfer coefficient is defined from structures, materials and the like of the cell and the assembled battery. As above, the temperature of the first battery in the occasion when the external temperature changes within the predetermined range is calculated on the basis of the heat amount of the storage battery 1, the specific heat of the storage battery 1, the heat transfer coefficient between the storage battery 1 and the outside, and the external temperature.

Notably, the end-point cell temperature may be expressed as the absolute value, or may be expressed as a relative value. In other words, the end-point cell temperature may be an actual cell temperature, or may be a difference from a cell temperature (initial temperature) at the time point when the cell starts to be exposed to an assumed high temperature.

Then, the safety index calculator 274 calculates the end-point cell temperature or a calculation value regarding the end-point cell temperature as a safety index. For example, a temperature change amount from the heat generation start temperature to the end-point cell temperature may be set to the safety index. Time taken from the heat generation start temperature to the end-point cell temperature may be set to the safety index. A heat generation speed from the heat generation start temperature to the end-point cell temperature may be set to the safety index. The heat generation speed may be set to a value obtained by dividing the temperature change amount by the time taken for the relevant temperature change.

The safety determiner 275 determines safety of the storage battery 1 on the basis of the calculated safety index. For example, the safety index may be compared with a threshold for the safety index. The threshold for the safety index is expressed as "safety threshold". The safety threshold may be predefined.

Notably, safety evaluation may include two of being safe (safe) and not being safe (being dangerous (danger)) with the safety threshold being as a reference. Otherwise, there may be a plurality of safety thresholds, and the safety evaluation may be categorized into a plurality of types such as being safe (safe), needing attention (attention), to be warned (warning), and to be stopped (stop). For example, when the end-point cell temperature which is the safety index is lower than a first safety threshold, "safe" may be determined. When the end-point cell temperature is not less than the first safety threshold and lower than a second safety threshold, "warning" may be determined. When the end-point cell temperature is not less than the second safety threshold, "danger" may be determined. To categorize the safety evaluation into a plurality of types in this way enhances convenience for a user.

Notably, the safety index calculated by the safety index calculator 274 may be used as the safety evaluation. In that case, the safety determiner 275 may be omitted.

Notably, when the heat amount calculator has determined that thermal runaway does not arise, the safety index calculator 274 is not needed to calculate a safety index. Further, the safety determiner 275 may determine that the storage battery 1 is "safe" since thermal runaway of the storage battery 1 does not arise.

Notably, as mentioned above, the battery characteristic estimator 25 can calculate the estimation value of the inner state parameter or the battery characteristic with high accuracy. Furthermore, by recalculating the estimation value of the inner state parameter or the battery characteristic on the basis of the internal resistance corrected by considering the electrolyte, the temperature and the like, the accuracy of the estimation value is enhanced. Since the heat amount, the end-point cell temperature and the like are estimated on the basis of the thermal stability data extracted with that highly accurate estimation value, the accuracy of safety determination from the safety index based on these becomes high.

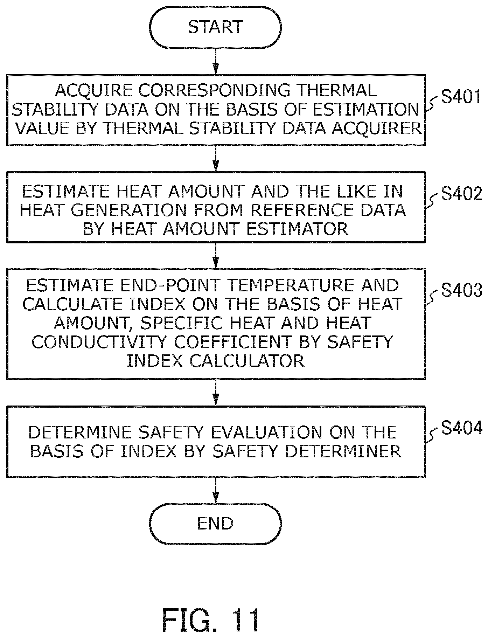

FIG. 11 is a diagram illustrating an example of a flowchart of the battery safety evaluation process. The battery safety evaluation process is performed after calculating the estimation value of the battery characteristic or the like of the storage battery 1 by the battery characteristic estimator 25 or the internal resistance corrector 26.

The thermal stability data acquirer 272 acquires the thermal stability data corresponding to the storage battery 1 from the thermal stability data storage 271 on the basis of the estimation value of the inner state parameter or the battery characteristic acquired from the battery characteristic estimator 25 or the internal-resistance corrector 26 (S401).

Notably, in the case where the thermal stability data storage 271 is realized by a database or the like, the battery characteristic or the like may be recorded as an attribute in association with the thermal stability data. In such a case, by using a management function such as RDBMS, the thermal stability data can be extracted on the basis of the estimation value of the battery characteristic or the like. Notably, the thermal stability data may be extracted even when the estimation value is within a predetermined range for the value of the battery characteristic or the like corresponding to the thermal stability data, the estimation data not completely coinciding with the thermal stability data.

The heat amount estimator 273 estimates the heat amounts and the like for the positive electrode and the negative electrode on the basis of the thermal stability data acquired by the thermal stability data acquirer 272 (S402). The safety index calculator 274 estimates the end-point cell temperature and calculates the safety index regarding the end-point cell temperature on the basis of the heat amount, the specific heat, the heat transfer coefficient and the external temperature (S403). The safety determiner 275 determines the safety evaluation on the basis of the safety index (S404). The above is a flow of the battery safety evaluation process. Notably, it is supposed that the safety evaluation is sent to the output device 28, but it may be sent to another component, for example, the thermal stability data storage 271.

Notably, when it is determined that the state of the storage battery 1 is changed, the battery safety evaluator 27 may perform the battery safety evaluation process. The battery characteristic estimator 25 may determine that the state of the storage battery 1 is changed, or the battery safety evaluator 27 may determine that. Otherwise, the state of the storage battery 1, the thermal stability data corresponding to the relevant state, and the like being output through the output device 28, a user of the storage battery 1, an administrator of the battery safety evaluation apparatus 2, or the like who has seen the relevant output may give an instruction through a not-shown input device.

The output device 28 outputs the calculated battery safety evaluation and the like. For example, when it is determined that thermal runaway of the storage battery 1 arises, the output device 28 may accept the external temperature in the occasion when the thermal runaway of the storage battery 1 arises, in other words, the thermal runaway temperature from the heat amount estimator 273, and output it. An output method is not specially limited but it may give a file, a mail, an image, sound, light and the like. For example, the battery safety evaluation apparatus 2 being connected to a display, a speaker and the like through the output device 28, the results of the processes of the components may be output to another device. For example, when the safety evaluation is "danger", an image or light warning a user may be displayed on the display in order to cause the user to recognize the danger, or warning sound may be output from the speaker. Notably, information output by the output device 28 is not specially limited. For example, information used for the battery safety evaluation, such as the inner state parameters, the battery characteristic, and the thermal stability data, may be output.

As above, according to the first arrangement, the inner state parameters and the battery characteristics of the storage battery 1 are estimated on the basis of the voltage and the current of the storage battery 1. Then, the safety index is calculated on the basis of the inner state parameters or the battery characteristics. Then, safety evaluation based on the safety index enables evaluation of present safety of the storage battery 1. Moreover, by using safety data relevant to the upper limit of the SOC of the storage battery 1, the safety evaluation becomes more restrict.

Moreover, since safety of the storage battery 1 can be evaluated on the basis of the voltage and the like, a function of directly measuring the inner state parameters is not needed, which can suppress costs for production of the safety evaluation apparatus.

(Second Arrangement)

The battery safety evaluation apparatus 2 of a second arrangement not only outputs the determined safety evaluation to an external device or the like, but also changes control regarding charge/discharge of the storage battery 1 in accordance with the determined safety evaluation.

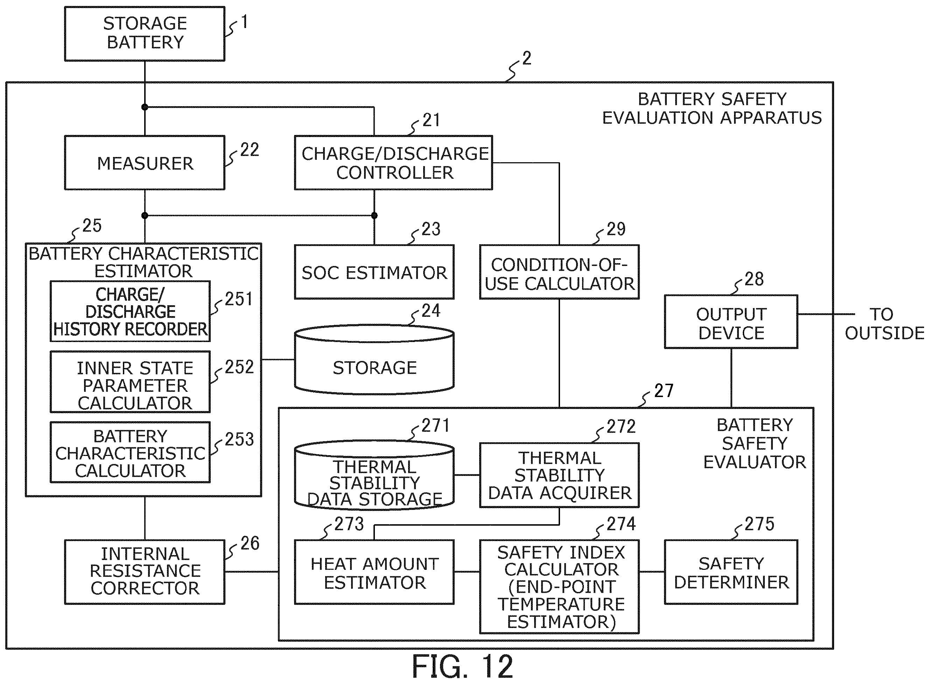

FIG. 12 is a block diagram illustrating an example of a schematic configuration of a power storage system according to the second arrangement. The second arrangement is different from the first arrangement in that the battery safety evaluation apparatus 2 further includes a condition-of-use calculator 29. Description of the same matters as those of the first arrangement is omitted.

It is supposed that the charge/discharge controller 21 controls charge/discharge not only for evaluating safety of the storage battery 1 but also for using the storage battery 1. Moreover, charge/discharge controller 21 changes control of charge/discharge in accordance with the safety evaluation made by the battery safety evaluator 27. For example, in the case of the safety evaluation that use is to be stopped, the charge/discharge controller 21 controls charge/discharge to be stopped. In the case of the safety evaluation that use may be continued, the charge/discharge controller 21 performs charge/discharge. In this stage, the charge/discharge is performed so as to satisfy a condition of use calculated by the condition-of-use calculator 29.

In the case of the safety evaluation that use may be continued but should be limited, the condition-of-use calculator 29 calculates (updates) the condition of use. For example, it is considered that in the case where a condition of use in the present state is continued when the safety evaluation is the aforementioned "attention", the safety evaluation soon becomes the aforementioned "danger". Therefore, when the safety evaluation is "attention", the condition of use is changed.

The conditions of use beforehand associated with the types of the safety evaluation, the condition-of-use calculator 29 may select the condition of use in accordance with the type of the safety evaluation. Otherwise, the condition-of-use calculator 29 may lower the upper limit of the SOC range usable for the storage battery 1. Since safety is lower as the SOC is larger as mentioned above, the upper limit is lowered down to a value at which the safety evaluation becomes "safe". Since the thermal stability data corresponding to the storage battery 1 is for each value of the SOC, evaluation is possibly "safe" in the case of 70% of SOC even when evaluation is "danger" at 100% of SOC. Therefore, the value of the SOC in the thermal stability data with which evaluation is "safe" out of the thermal stability data corresponding to the storage battery 1 may be set to the upper limit of the SOC.

Notably, in the case where the condition of use is not needed to be updated, for example, in the case of only two types of use to be continued and use to be stopped, the condition-of-use calculator 29 may be absent. Meanwhile, the charge/discharge controller 21 is not needed to perform charge/discharge on the basis of the condition of use created by the condition-of-use calculator 29. For example, the output device 28 outputting the created condition of use to an external device, the external device may charge/discharge the storage battery so as to satisfy the condition of use.

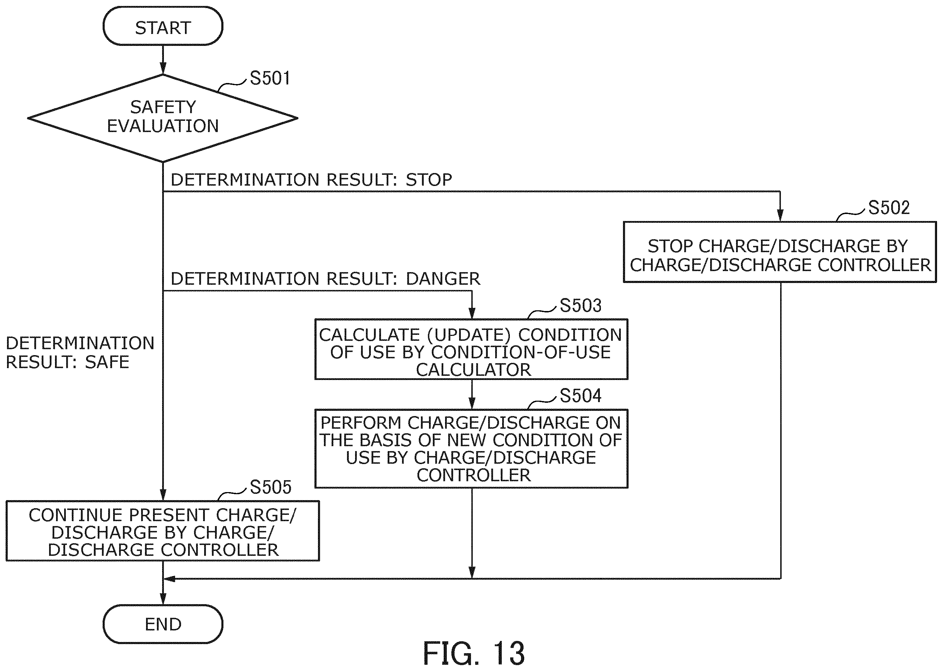

FIG. 13 is a diagram illustrating an example of a flowchart of schematic processes with the battery safety evaluation apparatus 2 of the second arrangement. FIG. 13 illustrates processes in and after S105 of the flowchart of the schematic processes illustrated in FIG. 2. The processes before and in S105 are the same, and hence, skipped in the figure. Notably, independently to the process of S105, this flow may be performed.

When the safety evaluation is "stop" ("STOP" in S501), the charge/discharge controller 21 stops charge/-discharge (S502). When the safety evaluation is "danger" ("DANGER" in S501), the condition-of-use calculator 29 calculates a new condition of use (S503). Then, the charge/discharge controller 21 performs charge/discharge on the basis of the new condition of use (S504). When the safety evaluation is "safe" ("SAFE" in S501), the charge/discharge controller 21 continues charge/discharge in the present state (S505). The above is a flow of the schematic processes with the battery safety evaluation apparatus 2 of the second arrangement.

As above, according to the second arrangement, charge/discharge of the storage battery 1 is controlled on the basis of the determined safety evaluation. By changing the charge/discharge to charge/discharge matching the present state of the storage battery 1, the life of the storage battery 1 can be elongated while securing safety of the storage battery 1.

(Third Arrangement)

In the aforementioned arrangements, the thermal stability data acquirer 272 acquires the thermal stability data corresponding to the storage battery 1 from the thermal stability data stored in the thermal stability data storage 271. However, since the states of the storage battery 1 are various, to store all the thermal stability data in the thermal stability data storage 271 needs the capacity of the thermal stability data storage 271 to be enlarged. Moreover, the thermal stability data storage 271 possibly does not have relevant thermal stability data corresponding to the storage battery 1. Therefore, in the third arrangement, the thermal stability data is externally acquired and updated. Thereby, the amount of the thermal stability data stored in the thermal stability data storage 271 can be reduced, and downsizing of the battery safety evaluator 27 and reduction of costs in production of the battery safety evaluator 27 can be realized. Moreover, types of corresponding storage batteries 1 can be increased.

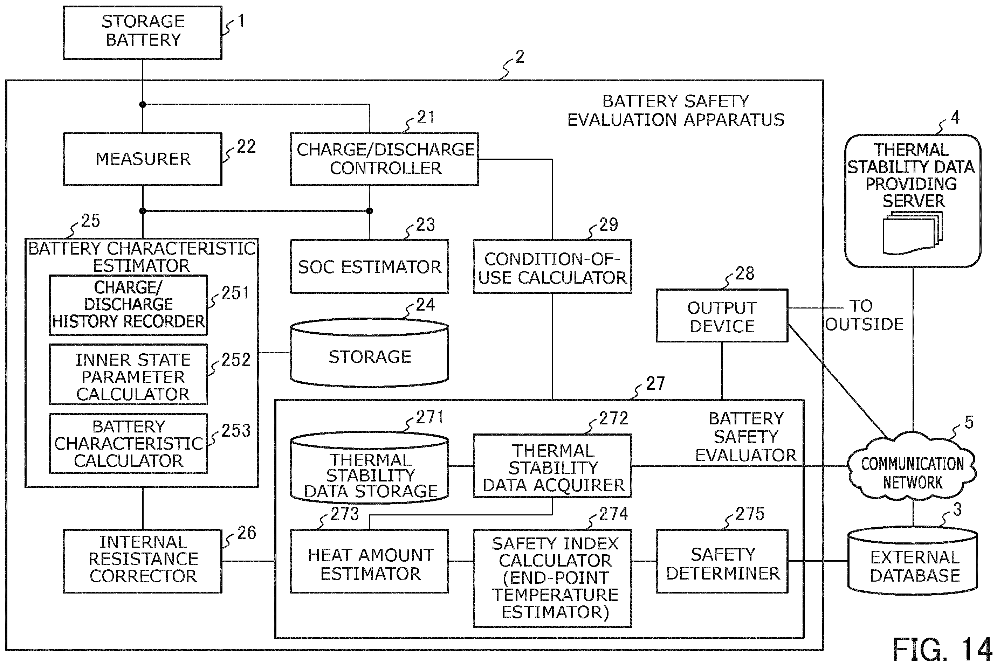

FIG. 14 is a block diagram illustrating an example of a schematic configuration of a power storage system according to the third arrangement. The third arrangement is different from the aforementioned arrangements in that the thermal stability data acquirer 272 is connected to the outside. Description of the same matters as those of the aforementioned arrangements is omitted.

The thermal stability data acquirer 272 is connected to a device or the like that provides thermal stability data via wired or wireless communication, or via an electric signal so as to transmit and receive data. The device or the like that provides thermal stability data is not limited to a particular device, and may be an external database 3 storing thermal stability data or may be a thermal stability data providing server 4 that generates and provides thermal stability data. Hereinafter, the device or the like that provides thermal stability data is referred to as "thermal stability data providing device". The thermal stability data acquirer 272 may be connected to the thermal stability data providing device via a communication network 5. Alternatively, the thermal stability data acquirer 272 may be connected directly or indirectly to the external database 3 via a device interface.

Acquisition of thermal stability data by the thermal stability data acquirer 272 is assumed to be performed when thermal stability data corresponding to the storage battery 1 is lacked. However, such a timing is not limited to a particular timing. For example, acquisition may be performed when the thermal stability data providing device generates new thermal stability data, or may be performed regularly. When necessary thermal stability data is not found in the thermal stability data storage 271, thermal stability data corresponding to the standard, battery characteristics, inner state parameters, or the like of the storage battery 1 is acquired on the basis thereof.

Thermal stability data may be acquired from the thermal stability data providing device without specifying a condition and the like. Thermal stability data which has been acquired but is considered not to be necessary may not be stored in the thermal stability data storage 271.

The thermal stability data storage 271 may delete thermal stability data stored therein. For example, for capacity saving, it is not necessary for the thermal stability data storage 271 to store therein thermal stability data satisfying a predetermined deletion condition, such as expired thermal stability data and thermal stability data which is seldom used.

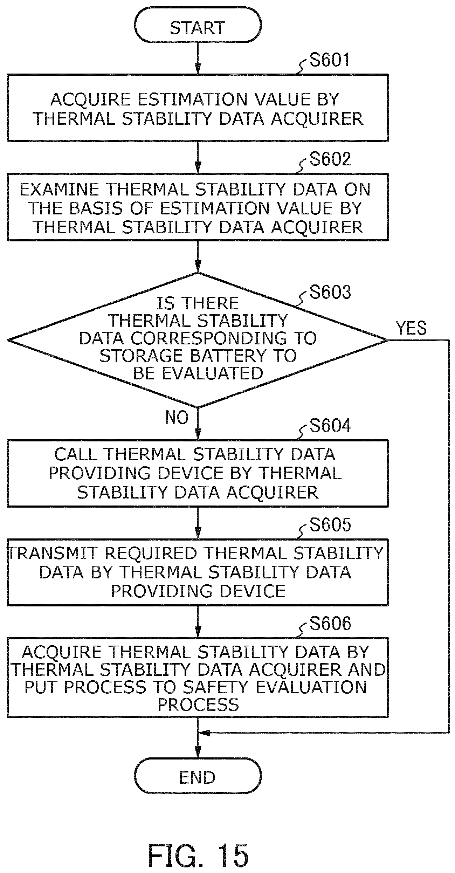

FIG. 15 is a diagram illustrating an example of a flowchart of a thermal stability data acquisition process. This flowchart illustrates a flow in the case where the thermal stability data is acquired before the battery safety evaluation process.

The thermal stability data acquirer 272 acquires the estimation value of a battery characteristic or the like of the storage battery 1 from the battery characteristic estimator 25 or the internal-resistance corrector 26 (S601). The thermal stability data acquirer 272 determines whether the thermal stability data storage 271 stores therein thermal stability data corresponding to the storage battery 1, on the basis of the acquired estimation value (S602).

When the thermal stability data storage 271 stores thermal stability data corresponding to the storage battery 1 (Yes at S603), the flow is ended. When the thermal stability data storage 271 does not store thermal stability data corresponding to the storage battery 1 (No at S603), the thermal stability data acquirer 272 sends an inquiry to the thermal stability data providing device (S604). The inquiry is assumed to include the acquired estimation value.

The thermal stability data providing device transmits thermal stability data corresponding for calculation of a charge pattern on the basis of the received estimation value of the battery characteristic or the like (S605). Subsequently, the thermal stability data acquirer 272 acquires the transmitted thermal stability data, and proceeds to the battery safety evaluation process (S606). The battery safety evaluation process is as above. The flow of the thermal stability data acquisition process has been described.

As described above, according to the third arrangement, even if thermal stability data required the battery safety evaluation process is not stored in the thermal stability data storage 271, required thermal stability data can be acquired on the basis of the battery characteristics or the like of the storage battery 1. Therefore, an amount of thermal stability data stored in the thermal stability data storage 271 can be reduced, and thereby downsizing of the battery safety evaluator 27 or reduction in cost for manufacturing the battery safety evaluator 27 can be achieved. Moreover, the number of types of the supported storage battery 1 can be increased.

Each process in the arrangements described above can be implemented by software (program). Thus, the arrangements described above can be implemented using, for example, a general-purpose computer apparatus as basic hardware and causing a processor mounted in the computer apparatus to execute the program.

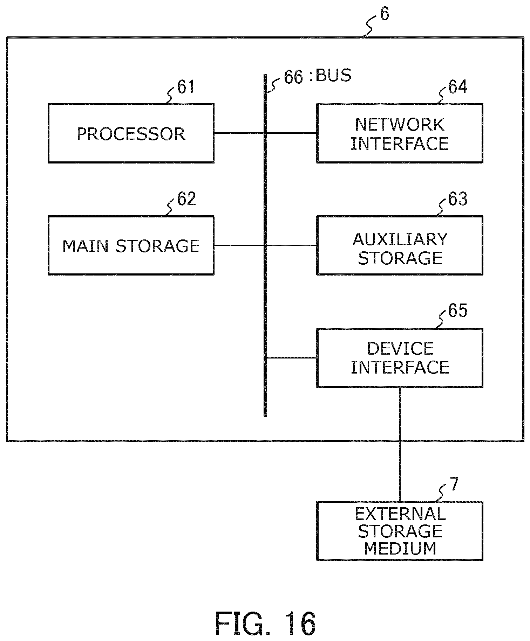

FIG. 16 is a block diagram illustrating an example of a hardware configuration according to an arrangement of the present invention. The battery safety evaluation apparatus 2 can be realized by a computer device 6 including a processor 61, a main storage 62, an auxiliary storage 63, a network interface 64, and a device interface 65, which are connected to one another via a bus 66.

The processor 61 reads out a program from the auxiliary storage 63, develops the program onto the main storage 62, and executes the program. As a result of this, functions of the charge/discharge controller 21, the measurer 22, the SOC estimator 23, the battery characteristic estimator 25, the internal-resistance corrector 26, and the battery safety evaluator 27 can be achieved.

The processor 61 is an electronic circuit including a controller and a calculator of a computer. As the processor 61, a general-purpose processor, a central processor (CPU), a microprocessor, a digital signal processor (DSP), a controller, a microcontroller, a state machine, an application specific integrated circuit, a field programmable gate array (FPGA), a programmable logic circuit (PLD), or the combination thereof can be used, for example.

The battery safety evaluation apparatus 2 of the present arrangement may be realized by installing a program to be executed by the components into the computer device 6 in advance, or installing the program, which is stored in a storage medium such as a CD-ROM or the like is distributed via a network, into the computer device 6, as appropriate.

The main storage 62 is a memory that temporarily stores an instruction to be executed by the processor 61, various types of data, and the like, and may be a volatile memory such as a DRAM, or may be a non-volatile memory such as an MRAM. The auxiliary storage 63 is a storage that permanently stores a program, data, and the like. For example, the auxiliary storage 63 is a flash memory, for example.

The network interface 64 is an interface for wired or wireless connection to a communication network. In the case where the thermal stability data acquirer 272 communicates with the thermal stability data providing device, the communication processing function of the thermal stability data acquirer 272 can be realized by the network interface 64. In the drawing, only one network interface 64 is illustrated, but a plurality of the network interfaces 64 may be mounted.

The device interface 65 is an interface such as a USB for connection to an external storage medium 7 that stores therein an output result and the like. In the case where the thermal stability data providing device is the external storage medium 7, a function for data exchange between the thermal stability data acquirer 272 and the external storage medium 7 can be realized by the device interface 65. The external storage medium 7 may be an arbitrary storage medium such as an HDD, a CD-R, a CD-RW, a DVD-RAM, a DVD-R, a SAN (storage area network), or the like. The external storage medium 7 may be connected to the storage battery 1 via the device interface 65.

The computer device 6 may be configured by dedicated hardware such as a semiconductor integrated circuit having the processor 61 mounted thereon. The dedicated hardware may be configured by combination with a storage such as an RAM or an ROM. The computer device 6 may be incorporated inside the storage battery 1.

**Claims**

1.    A battery safety evaluation apparatus comprising a computer apparatus configured to perform a process of:

a battery characteristic estimator (25) configured to estimate an estimation value of an inner state parameter of a first battery which is a secondary battery to be evaluated on the basis of data on voltage and current of the first battery measured in charging or discharging the first battery;

a heat estimator (273) configured to estimate a heat of the first battery upon change of an external temperature on the basis of first reference data which is reference data at least indicating relationship between a heat of a secondary battery and the external temperature and is set to correspond to the first battery on the basis of the estimation value; and

a safety index calculator (274) configured to calculate a safety index regarding a temperature of the first battery upon change of the external temperature on the basis of the heat of the first battery; to calculate the temperature of the first battery at the external temperature on the basis of the heat of the first battery estimated by the heat estimator, a specific heat of the first battery, a heat transfer coefficient between the first battery and an outside of the first battery, and the external temperature; and to calculate the safety index on the basis of the calculated temperature of the first battery.

2. The battery safety evaluation apparatus according to claim 1, wherein the computer apparatus is further configured to perform a process of:
a safety determiner (275) configured to determine safety of the first battery or an assembled battery including the first battery on the basis of the safety index.

3. The battery safety evaluation apparatus according to claim 2, wherein
the safety determiner (275) is configured to select an evaluation class matching the first battery from a plurality of evaluation classes on the basis of the safety index and a threshold for the safety index.

4. The battery safety evaluation apparatus according to any one of claims 1 to 3, wherein
the heat estimator (273) is configured to calculate an external temperature in the occasion when thermal runaway of the first battery arises on the basis of the first reference data as a thermal runaway temperature.

5. The battery safety evaluation apparatus according to any one of claims 1 to 4, further comprising
an output device (28) arranged for outputting the safety index or evaluation based on the safety index.

6. The battery safety evaluation apparatus according to claim 4, further comprising

an output device (28) arranged for outputting the safety index or evaluation based on the safety index, wherein the output device (28) is configured to output the thermal runaway temperature.

7. The battery safety evaluation apparatus according to claim 5 or 6, wherein
the output device (28) is configured to output content of output as an image.

8. The battery safety evaluation apparatus according to claim 5 or 6, wherein
the output device (28) is configured to output content of output as a file.

9. The battery safety evaluation apparatus according to claim 5 or 6, wherein
the output device (28) is configured to output an image, light or sound indicating warning on the basis of the safety index.

10. The battery safety evaluation apparatus according to any one of claims 1 to 9, wherein

the battery characteristic estimator (25) is configured to estimate an estimation value of a battery characteristic on the basis of the inner state parameter, and
the first reference data is set to correspond to the first battery on the basis of the estimation value of the battery characteristic.

11. The battery safety evaluation apparatus according to any one of claims 1 to 10, wherein the computer apparatus is further configured to perform a process of
a reference data acquirer (272) configured to acquire the first reference data on the basis of the estimation value.

12. A battery safety evaluation method performed by a computer apparatus, the method comprising:

estimating (S103) an estimation value of an inner state parameter of a first battery which is a secondary battery to be evaluated on the basis of data on voltage and current of the first battery measured in charging or discharging the first battery;

estimating (S402) a heat of the first battery upon change of an external temperature on the basis of first reference data which is reference data at least indicating relationship between a heat of a secondary battery and the external temperature and is set to correspond to the first battery on the basis of the estimation value; and

calculating (S403) a safety index regarding a temperature of the first battery upon change of the external temperature on the basis of the heat of the first battery; calculating the temperature of the first battery at the external temperature on the basis of the heat of the first battery estimated by the heat estimator, a specific heat of the first battery, a heat transfer coefficient between the first battery and an outside of the first battery, and the external temperature; and calculating the safety index on the basis of the calculated temperature of the first battery.

13. A computer program comprising instructions which, when executed by a computer apparatus, cause the computer apparatus to perform:

estimating (S103) an estimation value of an inner state parameter of a first battery which is a secondary battery to be evaluated on the basis of data on voltage and current of the first battery measured in charging or discharging the first battery;

estimating (S402) a heat of the first battery upon change of an external temperature on the basis of first reference data which is reference data at least indicating relationship between a heat of a secondary battery and the external temperature and is set to correspond to the first battery on the basis of the estimation value; and

calculating (S403) a safety index regarding a temperature of the first battery upon change of the external temperature on the basis of the heat of the first battery; calculating the temperature of the first battery at the external temperature on the basis of the heat of the first battery estimated by the heat estimator, a specific heat of the first battery, a heat transfer coefficient between the first battery and an outside of the first battery, and the external temperature; and calculating the safety index on the basis of the calculated temperature of the first battery.

**Patentansprüche**

1. Batteriesicherheitsevaluierungseinrichtung, die eine Computereinrichtung umfasst, die konfiguriert ist, einen Prozess auszuführen von:

einem Batteriecharakteristik-Schätzer (25), der konfiguriert ist, einen Schätzwert eines inneren Zustandsparameters einer ersten Batterie, die eine zu bewertende Sekundärbatterie ist, auf Basis von Daten über Spannung und Strom der ersten Batterie, die beim Laden oder Entladen der ersten Batterie gemessen werden, zu schätzen; einem Wärmeschätzer (273), der konfiguriert ist, Wärme der ersten Batterie bei einer Änderung einer Außentemperatur auf Basis von ersten Referenzdaten zu schätzen, die Referenzdaten sind, die zumindest eine Beziehung zwischen einer Wärme einer Sekundärbatterie und der Außentemperatur anzeigen und so eingestellt sind, dass sie der ersten Batterie auf Basis des Schätzwertes entsprechen; und einem Sicherheitsindexrechner (274), der konfiguriert ist, einen Sicherheitsindex in Bezug auf eine Temperatur der ersten Batterie bei einer Änderung der Außentemperatur auf Basis der Wärme der ersten Batterie zu berechnen; die Temperatur der ersten Batterie bei der Außentemperatur auf Basis der Wärme der ersten Batterie, die durch den Wärmeschätzer geschätzt wird, einer spezifischen Wärme der ersten Batterie, eines Wärmeübergangskoeffizienten zwischen der ersten Batterie und einer Außenseite der ersten Batterie und der Außentemperatur zu berechnen; und den Sicherheitsindex auf BaSIS der berechneten Temperatur der ersten Batterie zu berechnen.

2. Batteriesicherheitsevaluierungseinrichtung gemäß Anspruch 1, wobei die Computereinrichtung ferner konfiguriert ist, einen Prozess durchzuführen von:
einem Sicherheitsbestimmer (275), der konfiguriert ist, die Sicherheit der ersten Batterie oder einer zusammengesetzten Batterie, die die erste Batterie enthält, auf Basis des Sicherheitsindexes zu bestimmen.

3. Batteriesicherheitsevaluierungseinrichtung gemäß Anspruch 2, wobei
der Sicherheitsbestimmer (275) so konfiguriert ist, dass er auf Basis des Sicherheitsindex und eines Schwellenwerts für den Sicherheitsindex aus einer Vielzahl von Bewertungsklassen eine zur ersten Batterie passende Bewertungsklasse auswählt.

4. Batteriesicherheitsevaluierungseinrichtung gemäß einem der Ansprüche 1 bis 3, wobei der Wärmeschätzer (273) so konfiguriert ist, dass er eine Außentemperatur in dem Fall, in dem ein thermisches Durchgehen der ersten Batterie auftritt, auf Basis der ersten Referenzdaten als eine thermische Durchgangstemperatur berechnet.

5. Batteriesicherheitsevaluierungseinrichtung gemäß einem der Ansprüche 1 bis 4, ferner umfassend eine Ausgabevorrichtung (28), die zur Ausgabe des Sicherheitsindexes oder einer auf dem Sicherheitsindex basierenden Bewertung eingerichtet ist.

6. Batteriesicherheitsevaluierungseinrichtung gemäß Anspruch 4, ferner umfassend

    eine Ausgabevorrichtung (28), die zur Ausgabe des Sicherheitsindexes oder einer auf dem Sicherheitsindex basierenden Bewertung eingerichtet ist, wobei
    die Ausgabevorrichtung (28) so konfiguriert ist, dass sie die thermische Durchgangstemperatur ausgibt.

7. Batteriesicherheitsevaluierungseinrichtung gemäß Anspruch 5 oder 6, wobei die Ausgabevorrichtung (28) konfiguriert ist, den Inhalt der Ausgabe als Bild auszugeben.

8. Batteriesicherheitsevaluierungseinrichtung gemäß Anspruch 5 oder 6, wobei die Ausgabevorrichtung (28) konfiguriert ist, den Inhalt der Ausgabe als Datei auszugeben.

9. Batteriesicherheitsevaluierungseinrichtung gemäß Anspruch 5 oder 6, wobei die Ausgabevorrichtung (28) konfiguriert ist, ein Bild, ein Licht oder einen Ton auszugeben, das bzw. der eine Warnung auf Basis des Sicherheitsindexes angibt.

10. Batteriesicherheitsevaluierungseinrichtung gemäß einem der Ansprüche 1 bis 9, wobei

    der Batteriecharakteristik-Schätzer (25) konfiguriert ist, einen Schätzwert einer Batteriecharakteristik auf der Basis des inneren Zustandsparameters zu schätzen, und
    die ersten Referenzdaten so eingestellt werden, dass sie der ersten Batterie entsprechen, auf Basis des Schätzwerts der Batteriecharakteristik.

11. Batteriesicherheitsevaluierungseinrichtung gemäß einem der Ansprüche 1 bis 10, wobei die Computervorrichtung ferner konfiguriert ist, einen Prozess durchzuführen von einem Referenzdatenerfasser (272), der so konfiguriert ist, dass er die ersten Referenzdaten auf Basis des Schätzwerts erfasst.

12. Batteriesicherheitsevaluierungsverfahren, das von einer Computereinrichtung durchgeführt wird, wobei das Verfahren umfasst:

    Schätzen (S103) eines Schätzwertes eines inneren Zustandsparameters einer ersten Batterie, die eine zu bewertende Sekundärbatterie ist, auf Basis von Daten über Spannung und Strom der ersten Batterie, die beim Laden oder Entladen der ersten Batterie gemessen werden;
    Schätzen (S402) einer Wärme der ersten Batterie bei Änderung einer Außentemperatur auf Basis von ersten Referenzdaten, die Referenzdaten sind, die zumindest die Beziehung zwischen einer Wärme einer Sekundärbatterie und der Außentemperatur angeben und so eingestellt sind, dass sie der ersten Batterie auf Basis des Schätzwertes entsprechen; und
    Berechnen (S403) eines Sicherheitsindizes bezüglich einer Temperatur der ersten Batterie bei einer Änderung der Außentemperatur auf Basis der Wärme der ersten Batterie; Berechnen der Temperatur der ersten Batterie bei der Außentemperatur auf Basis der Wärme der ersten Batterie, die durch den Wärmeschätzer geschätzt wird, einer spezifischen Wärme der ersten Batterie, eines Wärmeübergangskoeffizienten zwischen der ersten Batterie und einer Außenseite der ersten Batterie und der Außentemperatur; und Berechnen des Sicherheitsindizes auf Basis der berechneten Temperatur der ersten Batterie.

13. Computerprogramm, das Anweisungen enthält, die, wenn sie von einer Computereinrichtung ausgeführt werden, die Computereinrichtung veranlassen, durchzuführen:

Schätzen (S103) eines Schätzwertes eines inneren Zustandsparameters einer ersten Batterie, die eine zu bewertende Sekundärbatterie ist, auf Basis von Daten über Spannung und Strom der ersten Batterie, die beim Laden oder Entladen der ersten Batterie gemessen werden;

Schätzen (S402) einer Wärme der ersten Batterie bei Änderung einer Außentemperatur auf Basis von ersten Referenzdaten, die Referenzdaten sind, die zumindest die Beziehung zwischen einer Wärme einer Sekundärbatterie und der Außentemperatur angeben und so eingestellt sind, dass sie der ersten Batterie auf Basis des Schätzwertes entsprechen; und

Berechnen (S403) eines Sicherheitsindizes bezüglich einer Temperatur der ersten Batterie bei einer Änderung der Außentemperatur auf Basis der Wärme der ersten Batterie; Berechnen der Temperatur der ersten Batterie bei der Außentemperatur auf Basis der Wärme der ersten Batterie, die durch den Wärmeschätzer geschätzt wird, einer spezifischen Wärme der ersten Batterie, eines Wärmeübergangskoeffizienten zwischen der ersten Batterie und einer Außenseite der ersten Batterie und der Außentemperatur; und Berechnen des Sicherheitsindizes auf Basis der berechneten Temperatur der ersten Batterie.

**Revendications**

1. Un appareil d'évaluation de sécurité de batterie comprenant un appareil informatique configuré pour exécuter un processus comprenant :

   un estimateur de caractéristique de batterie (25) configuré pour estimer une valeur d'estimation d'un paramètre d'état interne d'une première batterie qui est une batterie secondaire à être évaluée sur la base de données sur une tension et un courant de la première batterie mesurées lors de la charge ou de la décharge de la première batterie ;

   un estimateur de chaleur (273) configuré pour estimer une chaleur de la première batterie lors d'un changement d'une température externe sur la base de premières données de référence qui sont des données de référence indiquant au moins une relation entre une chaleur d'une batterie secondaire et la température externe et qui sont définies pour correspondre à la première batterie sur la base de la valeur estimée ; et

   un calculateur d'indice de sécurité (274) configuré pour calculer un indice de sécurité concernant une température de la première batterie lors d'un changement de la température externe sur la base de la chaleur de la première batterie ; pour calculer la température de la première batterie à la température externe sur la base de la chaleur de la première batterie estimée par l'estimateur de chaleur, d'une chaleur spécifique de la première batterie, d'un coefficient de transfert thermique entre la première batterie et un extérieur de la première batterie, et de la température externe ; et pour calculer l'indice de sécurité sur la base de la température calculée de la première batterie.

2. L'appareil d'évaluation de sécurité de batterie selon la revendication 1, dans lequel l'appareil informatique est en outre configuré pour exécuter un processus consistant à :

   un dispositif de détermination de sécurité (275) configuré pour déterminer une sécurité de la première batterie ou d'une batterie assemblée comprenant la première batterie sur la base de l'indice de sécurité.

3. L'appareil d'évaluation de sécurité de batterie selon la revendication 2, dans lequel
   le dispositif de détermination de sécurité (275) est configuré pour sélectionner une classe d'évaluation correspondant à la première batterie parmi une pluralité de classes d'évaluation sur la base de l'indice de sécurité et d'un seuil pour l'indice de sécurité.

4. L'appareil d'évaluation de sécurité de batterie selon l'une quelconque des revendications 1 à 3, dans lequel l'estimateur de chaleur (273) est configuré pour calculer une température externe dans le cas où un emballement thermique de la première batterie se produit sur la base des premières données de référence en tant qu'une température d'emballement thermique.

5. L'appareil d'évaluation de sécurité de batterie selon l'une quelconque des revendications 1 à 4, comprenant en outre un dispositif de sortie (28) agencé pour fournir en sortie l'indice de sécurité ou une évaluation sur la base de l'indice de sécurité.

6. L'appareil d'évaluation de sécurité de batterie selon la revendication 4, comprenant en outre

un dispositif de sortie (28) agencé pour fournir en sortie l'indice de sécurité ou une évaluation sur la base de l'indice de sécurité, dans lequel
le dispositif de sortie (28) est configuré pour fournir en sortie la température d'emballement thermique.

7. L'appareil d'évaluation de sécurité de batterie selon la revendication 5 ou 6, dans lequel
le dispositif de sortie (28) est configuré pour fournir en sortie un contenu d'une sortie sous forme d'image.

8. L'Appareil d'évaluation de sécurité de batterie selon la revendication 5 ou 6, dans lequel
le dispositif de sortie (28) est configuré pour fournir en sortie un contenu d'une sortie sous forme de fichier.

9. L'appareil d'évaluation de sécurité de batterie selon la revendication 5 ou 6, dans lequel
le dispositif de sortie (28) est configuré pour fournir en sortie une image, une lumière ou un son indiquant un avertissement sur la base de l'indice de sécurité.

10. L'appareil d'évaluation de sécurité de batterie selon l'une quelconque des revendications 1 à 9, dans lequel

l'estimateur de caractéristique de batterie (25) est configuré pour estimer une valeur d'estimation d'une caractéristique de batterie sur la base du paramètre d'état interne, et
les premières données de référence sont définies pour correspondre à la première batterie sur la base de la valeur d'estimation de la caractéristique de batterie.

11. L'appareil d'évaluation de sécurité de batterie selon l'une quelconque des revendications 1 à 10, dans lequel l'appareil informatique est en outre configuré pour exécuter un processus consistant à
un dispositif d'acquisition de données de référence (272) configuré pour acquérir les premières données de référence sur la base de la valeur d'estimation.

12. Un procédé d'évaluation de sécurité de batterie exécuté par un appareil informatique, le procédé comprenant :

l'estimation (S103) d'une valeur d'estimation d'un paramètre d'état interne d'une première batterie qui est une batterie secondaire à être évaluée sur la base de données sur une tension et un courant de la première batterie mesurées lors de la charge ou de la décharge de la première batterie ;
l'estimation (S402) d'une chaleur de la première batterie lors d'un changement d'une température externe sur la base de premières données de référence qui sont des données de référence indiquant au moins une relation entre une chaleur d'une batterie secondaire et la température externe et qui sont définies pour correspondre à la première batterie sur la base de la valeur d'estimation ; et
le calcul (S403) d'un indice de sécurité concernant une température de la première batterie lors d'un changement de la température externe sur la base de la chaleur de la première batterie ; le calcul de la température de la première batterie à la température externe sur la base de la chaleur de la première batterie estimée par l'estimateur de chaleur, d'une chaleur spécifique de la première batterie, d'un coefficient de transfert thermique entre la première batterie et un extérieur de la première batterie, et de la température externe ; et le calcul de l'indice de sécurité sur la base de la température calculée de la première batterie.

13. Un programme informatique comprenant des instructions qui, lorsqu'elles sont exécutées par un appareil informatique, amènent l'appareil informatique à effectuer les opérations suivantes :

l'estimation (S103) d'une valeur d'estimation d'un paramètre d'état interne d'une première batterie qui est une batterie secondaire à être évaluée sur la base de données sur une tension et un courant de la première batterie mesurées lors de la charge ou de la décharge de la première batterie ;
l'estimation (S402) d'une chaleur de la première batterie lors d'un changement d'une température externe sur la base de premières données de référence qui sont des données de référence indiquant au moins une relation entre une chaleur d'une batterie secondaire et la température externe et qui sont définies pour correspondre à la première batterie sur la base de la valeur d'estimation ; et
le calcul (S403) d'un indice de sécurité concernant une température de la première batterie lors d'un changement de la température externe sur la base de la chaleur de la première batterie ; le calcul de la température de la première batterie à la température externe sur la base de la chaleur de la première batterie estimée par l'estimateur de chaleur, d'une chaleur spécifique de la première batterie, d'un coefficient de transfert thermique entre la première batterie et un extérieur de la première batterie, et de la température externe ; et le calcul de l'indice de sécurité sur la base de la température calculée de la première batterie.

FIG. 1

START

GIVE INSTRUCTION TO BE CHARGED (DISCHARGED) BY CHARGE/ DISCHARGE CONTROLLER    S101

ACQUIRE CHARGE (DISCHARGE) DATA BY MEASURER    S102

CALCULATE INNER STATE PARAMETERS AND BATTERY CHARACTERISTICS FROM MEASUREMENT DATA BY BATTERY CHARACTERISTIC ESTIMATOR    S103

CALCULATE SAFETY INDEX FROM INNER STATE PARAMETERS OR BATTERY CHARACTERISTICS BY BATTERY SAFETY DETERMINER    S104

EVALUATE SAFETY ON THE BASIS OF SAFETY INDEX BY BATTERY SAFETY DETERMINER    S105

OUTPUT SAFETY EVALUATION BY OUTPUT DEVICE    S106

END

FIG. 2

FIG. 3

```
            ┌─────────┐
            │  START  │
            └─────────┘
                 │              S201
                 ▼
  ┌──────────────────────────────┐
  │    PERFORM INITIALIZATION     │
  └──────────────────────────────┘
                 │              S202
                 ▼
  ┌──────────────────────────────┐
  │      CALCULATE RESIDUAL       │
  └──────────────────────────────┘
                 │              S203
                 ▼
  ┌──────────────────────────────┐
  │  CALCULATE UPDATE STEP WIDTH  │
  └──────────────────────────────┘
                 │                    S204
                 ▼
         ◇ UPDATE STEP WIDTH EQUAL TO
  NO ◇    OR GREATER THAN THRESHOLD? ◇
                 │ YES
                 ▼                    S205
         ◇ REPEAT COUNT EXCEEDS      NO
         ◇ THRESHOLD? ◇ ──────────────┐
                 │ YES                 │   S206
                 ▼                     ▼
  ┌──────────────────────┐  ┌──────────────────────────┐
  │ OUTPUT PARAMETER SET │  │ ADD UPDATE STEP WIDTH TO  │
  └──────────────────────┘  │   PARAMETER SET AND       │
             │   S207       │ INCREMENT REPEAT COUNT    │
             ▼              └──────────────────────────┘
        ┌─────────┐
        │   END   │
        └─────────┘
```

FIG. 4

START

S301
SET INITIAL VALUE OF $q_n$

S302
CALCULATE OPEN CIRCUIT VOLTAGE

S303
LESS THAN LOWER LIMIT VOLTAGE?

NO →

S304
SUBTRACT $\Delta q_n$ FROM CHARGE AMOUNT $q_n$

YES

S305
ADD $\Delta q_n$ TO CHARGE AMOUNT $q_n$

S306
CALCULATE OPEN CIRCUIT VOLTAGE

S307
EQUAL TO OR GREATER THAN LOWER LIMIT VOLTAGE?

NO

YES

S308
RECORD CHARGE AMOUNT AND OPEN CIRCUIT VOLTAGE

S309
ADD $\Delta q_n$ TO CHARGE AMOUNT $q_n$

S310
CALCULATE OPEN CIRCUIT VOLTAGE

S311
RECORD CHARGE AMOUNT AND OPEN CIRCUIT VOLTAGE

S312
EQUAL TO OR GREATER THAN UPPER LIMIT VOLTAGE?

NO

YES

END

FIG. 5

FIG. 6A

FIG. 6B

FIG. 7

FIG. 8

FIG. 9

FIG. 10

START

ACQUIRE CORRESPONDING THERMAL STABILITY DATA ON THE BASIS OF ESTIMATION VALUE BY THERMAL STABILITY DATA ACQUIRER — S401

ESTIMATE HEAT AMOUNT AND THE LIKE IN HEAT GENERATION FROM REFERENCE DATA BY HEAT AMOUNT ESTIMATOR — S402

ESTIMATE END-POINT TEMPERATURE AND CALCULATE INDEX ON THE BASIS OF HEAT AMOUNT, SPECIFIC HEAT AND HEAT CONDUCTIVITY COEFFICIENT BY SAFETY INDEX CALCULATOR — S403

DETERMINE SAFETY EVALUATION ON THE BASIS OF INDEX BY SAFETY DETERMINER — S404

END

# FIG. 11

FIG. 12

EP 3 376 585 B1

```
                    ┌─────────┐
                    │  START  │
                    └────┬────┘
                         │
                       ◇ S501
                 SAFETY
               EVALUATION
                    │
   DETERMINATION RESULT: STOP
                                        ┌─── S502
                                ┌──────────────────────────┐
                                │ STOP CHARGE/DISCHARGE BY  │
                                │ CHARGE/DISCHARGE CONTROLLER│
                                └──────────────────────────┘
   DETERMINATION RESULT: DANGER
                              ┌─── S503
                     ┌──────────────────────────┐
                     │ CALCULATE (UPDATE) CONDITION│
                     │ OF USE BY CONDITION-OF-USE │
                     │        CALCULATOR          │
                     └──────────────────────────┘
                              ┌─── S504
                     ┌──────────────────────────┐
DETERMINATION        │ PERFORM CHARGE/DISCHARGE ON│
RESULT: SAFE         │ THE BASIS OF NEW CONDITION OF│
                     │ USE BY CHARGE/DISCHARGE   │
                     │        CONTROLLER          │
                     └──────────────────────────┘
         ┌─── S505
 ┌──────────────────────┐
 │ CONTINUE PRESENT CHARGE/│
 │ DISCHARGE BY CHARGE/   │
 │ DISCHARGE CONTROLLER   │
 └──────────────────────┘
         │
    ┌─────────┐
    │   END   │
    └─────────┘
```

START

S501

SAFETY
EVALUATION

DETERMINATION RESULT: STOP

S502

STOP CHARGE/DISCHARGE BY
CHARGE/DISCHARGE CONTROLLER

DETERMINATION RESULT: DANGER

S503

CALCULATE (UPDATE) CONDITION
OF USE BY CONDITION-OF-USE
CALCULATOR

S504

PERFORM CHARGE/DISCHARGE ON
THE BASIS OF NEW CONDITION OF
USE BY CHARGE/DISCHARGE
CONTROLLER

DETERMINATION
RESULT: SAFE

S505

CONTINUE PRESENT CHARGE/
DISCHARGE BY CHARGE/
DISCHARGE CONTROLLER

END

FIG. 13

FIG. 14

START

S601

ACQUIRE ESTIMATION VALUE BY
THERMAL STABILITY DATA ACQUIRER

S602

EXAMINE THERMAL STABILITY DATA ON
THE BASIS OF ESTIMATION VALUE BY
THERMAL STABILITY DATA ACQUIRER

S603

IS THERE
THERMAL STABILITY
DATA CORRESPONDING TO
STORAGE BATTERY TO
BE EVALUATED

YES

NO

S604

CALL THERMAL STABILITY DATA
PROVIDING DEVICE BY THERMAL
STABILITY DATA ACQUIRER

S605

TRANSMIT REQUIRED THERMAL STABILITY
DATA BY THERMAL STABILITY DATA
PROVIDING DEVICE

S606

ACQUIRE THERMAL STABILITY DATA BY
THERMAL STABILITY DATA ACQUIRER AND
PUT PROCESS TO SAFETY EVALUATION
PROCESS

END

FIG. 15

FIG. 16

**EP 3 376 585 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20160380313 A1